# EUROPEAN PATENT SPECIFICATION

(11) **EP 2 393 307 B1**
(45) Date of publication and mention of the grant of the patent: **09.01.2019**
(21) Application number: 11166777.0
(22) Date of filing: 19.05.2011
(51) Int. Cl.: H04R 19/04, B81B 7/00, B81C 1/00, H04R 19/00

(54) **Semiconductor device and microphone**
Halbleitervorrichtung und Mikrofon
Dispositif semi-conducteur et microphone

(30) Priority: 01.06.2010 JP 2010125527
(43) Date of publication of application: 07.12.2011
(73) Proprietor: Omron Corporation, Kyoto-shi, Kyoto 600-8530 (JP)
(72) Inventor: Kuratani, Naoto, Kyoto-shi Kyoto 600-8530 (JP); Maekawa, Tomofumi, Kyoto-shi, Kyoto 600-8530 (JP)
(74) Representative: Kilian Kilian & Partner

(56) References cited:
- WO-A2-2008/067431
- JP-A- 2008 002 953
- US-A1- 2008 164 545
- US-A1- 2008 315 333

## Description

### BACKGROUND OF THE INVENTION

### 1. TECHNICAL FIELD

The present invention relates to semiconductor devices and microphones, and specifically, to a semiconductor device in which a semiconductor element is accommodated in a package. The present invention also relates to a microphone in which a microphone chip (acoustic sensor) is accommodated in the package.

### 2. RELATED ART

Miniaturization is demanded on electronic devices particularly portable devices, and to this end, components need to be mounted at high density on a small circuit substrate. The occupying area at the time of mounting of the components (hereinafter referred to as the mounting area) needs to be small in order to enable high density mounting of the components. The microphone chip and the circuit element are mounted in the package in the case of a MEMS (Micro Electro Mechanical Systems) microphone, whereas the microphone chip and the circuit element are installed side by side on the same surface of the substrate or the cover of the package in the conventional microphone. It is thus difficult to reduce the mounting area as there is a limit to reducing the mounting area of the microphone.

The inventors of the present invention conceived that the mounting area of the microphone can be reduced by arranging the microphone chip and the circuit element one above the other in the package to reduce the bottom area of the package.

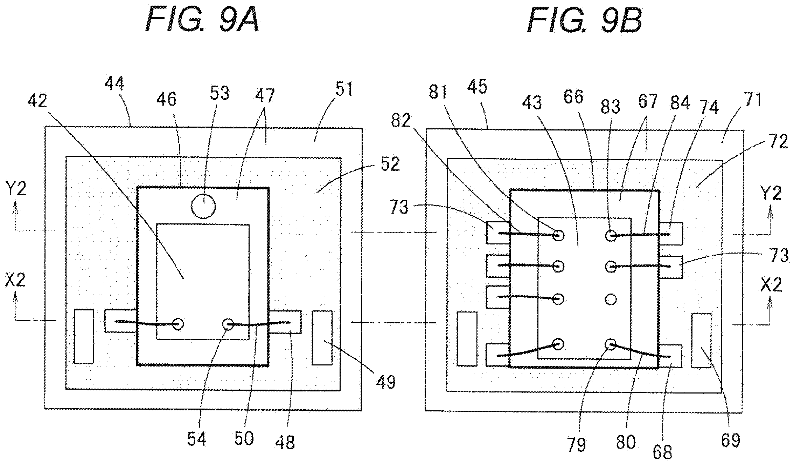

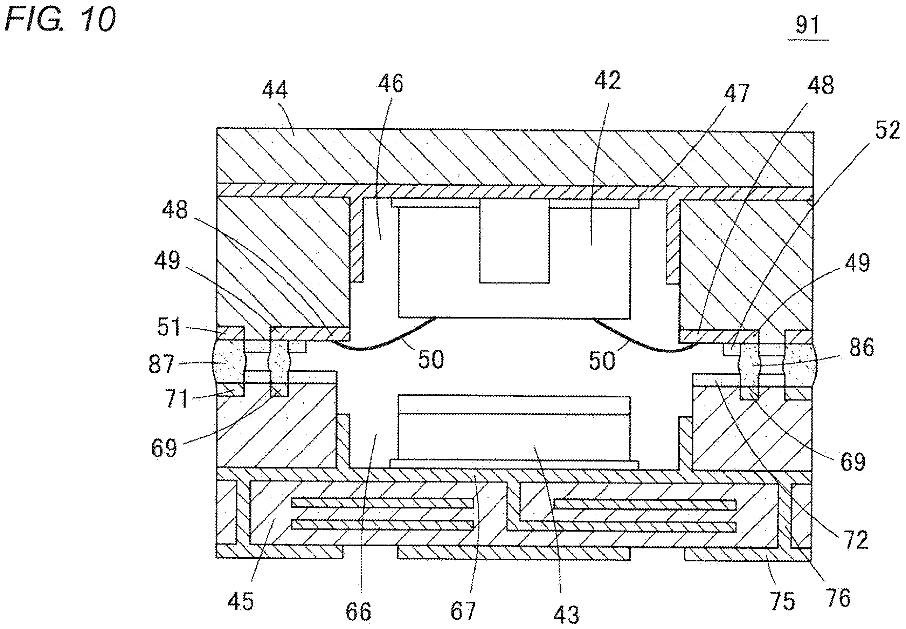

As a result of examining the documents of the prior art, the microphone disclosed in US Pat. No. 7166910 (Fig. 9, Fig. 10) was found in which the microphone chip and the circuit element are arranged one over the other. In the microphone of US Pat. No. 7166910 (Fig. 9, Fig. 10), the circuit element is mounted on the upper surface of the substrate, of the substrate and the cover that configure the package, and the microphone chip is mounted on the top surface of the cover.

In the microphone disclosed in US Pat. No. 7166910 (Fig. 9, Fig. 10), the circuit element and a shield metal are arranged side by side on the upper surface of the substrate, and the microphone chip is arranged on the top surface of the cover so as to be positioned immediately above the shield metal. Therefore, when the microphone is viewed from the upper side perpendicularly, the microphone chip and the circuit element are not overlapping. Although the circuit element and the microphone chip are arranged one over the other in such a microphone of US Pat. No. 7166910 (Fig. 9, Fig. 10), it is not aimed to reduce the mounting area and a structure for reducing the mounting area is not adopted.

Furthermore, the circuit element and the microphone chip need to be connected inside the package, but such a connection method becomes a problem if the circuit element is mounted on the substrate and the microphone chip is mounted on the cover. For example, if the circuit element mounted on the substrate and the microphone chip mounted on the cover are connected with a bonding wire, and then the cover is overlapped on the substrate, the circuits may short circuit by the bonding wire. US Pat. No. 7166910 (Fig. 9, Fig. 10) does not disclose the wiring method for connecting the circuit element and the microphone chip.

Similar wiring method problem arises when the circuit element and the microphone chip are both arranged on the cover. The method for connecting the circuit element and the microphone chip becomes a problem if the circuit element is arranged on the substrate and the microphone chip is arranged on the cover, and the method for connecting the circuit element and the substrate becomes a problem if the circuit element and the microphone chip are arranged on the cover.

The method for connecting the circuit element arranged on the cover and the substrate is disclosed in US Patent Application Publication Nos. 2008/0175425, 2008/0283988, and 2007/0058826. In US Patent Application Publication No. 2008/0175425, the circuit element and the microphone chip are mounted side by side on the top surface of the cover, and the circuit element and the substrate are connected by way of a solder ball in the package. With such a method, however, the wiring with the solder ball becomes complex and connection failure may occur due to positional shift of the solder ball, or the like, and hence the yield of the microphone may lower.

In the microphone of US Patent Application Publication No. 2008/0283988, the circuit element and the microphone chip are mounted side by side on the top surface of the cover, and a wiring pattern is provided on the side wall of the inner surface of the cover. The end of the wiring pattern positioned at the top surface of the cover and the circuit element are connected with the bonding wire, and the other end of the wiring pattern is connected to the substrate by overlapping the cover on the substrate. With the structure of US Patent Application Publication No. 2008/0283988, however, the manufacturing cost is high since the wiring pattern needs to be formed over the entire height of the side wall from the top surface of the cover. Furthermore, a space for inserting the wire bonding jig (capillary) is required since wire bonding needs to be carried out to the end of the wiring pattern at the corner of the cover, and hence the mounting area of the microphone becomes greater.

In the microphone of US Patent Application Publication No. 2008/0058826, the circuit element and the microphone chip are mounted on the inner surface of the cover, the circuit element and the microphone chip are connected to an electrode pad at the inner surface of the cover by the bonding wire, and the electrode pad of the cover is connected to the substrate by a through-hole and a coil spring formed inside a side wall portion (side substrate) of the circuit element cover. With the structure of US Patent Application Publication No. 2008/0058826, however, the structures such as the through-hole and the coil spring need to be formed at the side wall portion of the cover, and hence the package structure becomes complex and the manufacturing cost of the microphone becomes high. Furthermore, the mounting area of the package disadvantageously becomes large since the wall thickness of the side wall portion cannot be reduced.

US 2008/164545 A1 describes a MEMS microphone package. It includes a carrier, an application specific IC, an encapsulant and a microphone chip. The application specific IC and the microphone chip are respectively disposed on first and second surfaces of the carrier, and the application specific IC and the microphone chip are electrically connected to the carrier. The encapsulant includes first and second encapsulants, the first encapsulant is formed on the first surface to seal the application specific IC, the second encapsulant is formed on the second surface to become a cavity and the microphone chip is located at the cavity.

WO 2008/067431 A2 describes a microphone system. It has a base with at least one electrical port for electrically communicating with an external device. The system also has a solid metal lid coupled to the base to form an internal chamber, and a silicon microphone secured to the lid within the chamber. The lid has an aperture for receiving an audible signal, while the microphone is electrically connected to the electrical port of the base.

JP 2008 002953 A describes a semiconductor device, which comprises: a semiconductor chip; a circuit chip connected electrically thereto; and a shield case for containing them; wherein the semiconductor chip is arranged so as to be stacked on the surface of the circuit chip in such the state that the diaphragm faces the circuit chip.

US 2008/315333 A1 describes a substrate-level assembly having a device substrate of semiconductor material with a top face and housing a first integrated device, including a buried cavity formed within the device substrate, and with a membrane suspended over the buried cavity in the proximity of the top face. A capping substrate is coupled to the device substrate above the top face so as to cover the first integrated device in such a manner that a first empty space is provided above the membrane. Electrical-contact elements electrically connect the integrated device with the outside of the substrate-level assembly.

### SUMMARY

The present invention has been devised to solve the problems described above, and a first object thereof is to provide a semiconductor device (particularly, microphone) with a small mounting area. A second object of the present invention is to enable a sensor chip and a circuit element to be connected with a simple structure in a semiconductor element in which the sensor chip and the circuit element are mounted on different members that configure a package.

In accordance with the invention, there is provided a semiconductor device according to claim 1 or claim 2.

In the semiconductor device of the present invention, the sensor and the circuit element are arranged so as to partially overlap when viewed from the direction perpendicular to the bottom surface of the package, and hence the bottom area of the package can be reduced compared to when mounting the sensor and the circuit element side by side on the same surface. The mounting area of the semiconductor device thus can be reduced.

According to the semiconductor device of claim 1, the sensor and the circuit element can be connected with a simple structure through the first and second wire wirings, the first and second bonding pads, and the conductive material. Furthermore, since the first and second bonding pads are respectively arranged on the front surface of the first member and the second member, the first bonding pad and the second bonding pad can be joined with the conductive material when overlapping the first member and the second member to form a package, and the sensor and the circuit element can be easily connected without short circuiting. Moreover, since the first and second bonding pads are respectively arranged on the front surface of the first member and the second member, the wiring task of the first wire wiring and the second wire wiring can be easily carried out.

According to the semiconductor device of claim 2, the sensor and the circuit element can be connected with a simple structure through the first and second wire wirings, the first and second bonding pads, the first and second joining portions and the conductive material. Furthermore, since the first and second bonding pads and the first and second joining portions are respectively arranged on the front surface of the first member and the second member, the first joining portion and the second joining portion can be joined with the conductive material when overlapping the first member and the second member to form a package, and the sensor and the circuit element can be easily connected without short circuiting. Moreover, since the bonding pad for connecting the wire wiring and the joining portion for joining with the conductive material are separated, the assembly task of the semiconductor device is facilitated.

The conductive member may be at least one of solder, conductive resin, conductive tape or wax material.

In this aspect, the first bonding pad and the first joining portion are formed from a continuous metal film, the first bonding pad and the first joining portion being partitioned by partially covering a front surface of the metal film with an insulating film, and the second bonding pad and the second joining portion are formed from a continuous metal film, the second bonding pad and the second joining portion being partitioned by partially covering a front surface of the metal film with an insulating film. According to such an aspect, the conductive material for joining the joining portions is less likely to flow out to the bonding pad side since each bonding pad and each joining portion are separated by an insulating film such as the solder resist.

Yet another aspect of the present invention provides the semiconductor device wherein a front surface of the second member is partially removed in a region facing the first bonding pad to form a space for escaping the first wire wiring. According to such an aspect, the first wire wiring can be prevented from hitting the second member and being bent, or short circuited.

Yet another aspect of the present invention provides the semiconductor device wherein a front surface of the first member is partially removed in a region facing the second bonding pad to form a space for escaping the second wire wiring. According to such an aspect, the second wire wiring can be prevented from hitting the first member and being bent, or short circuited.

Yet another aspect of the present invention provides the semiconductor device wherein the sensor is mounted in the recess formed in the first member, and a corner of a peripheral wall portion surrounding the recess of the first member is depressed in a passing region of the first wire wiring. According to such an aspect, the first wire wiring can be prevented from being brought into contact with the conductive layer of the first member and causing short circuit in the sensor.

Yet another aspect of the present invention provides the semiconductor device wherein the circuit element is mounted in the recess formed in the second member, and a corner of a peripheral wall portion surrounding the recess of the second member is depressed in a passing region of the second wire wiring. According to such an aspect, the second wire wiring can be prevented from being brought into contact with the conductive layer of the second member and causing short circuit in the circuit element.

Yet another aspect of the present invention provides the semiconductor device wherein the first member is a cover of the package, and the second member is a substrate of the package.

Yet another aspect of the present invention provides the semiconductor device wherein the first member is a substrate of the package, and the second member is a cover of the package.

Yet another aspect of the present invention provides the semiconductor device wherein the cover and the substrate respectively include the recess. According to such an aspect, the high and low difference between the first bonding pad and the front surface of the sensor is reduced since the sensor is accommodated in the recess, so that the connection task of the first wire wiring is facilitated. Furthermore, the high and low difference between the second bonding pad and the front surface of the circuit element is reduced since the circuit element is also accommodated in the recess, so that the connection task of the second wire wiring is facilitated.

Yet another aspect of the present invention provides the semiconductor device wherein the cover includes the recess, and the substrate is formed to a flat plate shape. According to such an aspect, the high and low difference between the first bonding pad and the front surface of the sensor is reduced since the sensor is accommodated in the recess, so that the connection task of the first wire wiring is facilitated. The structure of the substrate is simplified since the substrate has a flat plate shape, and the cost becomes low.

In the semiconductor device according to the present invention, at least one material of a copper laminated stacked plate, glass epoxy, ceramic, plastic, metal, or carbon nano tube, or a complex material thereof can be used for the material of the first member. Furthermore, at least one material of a copper laminated stacked plate, glass epoxy, ceramic, plastic, metal, or carbon nano tube, or a complex material thereof can be used for the material of the second member. Moreover, the first member and the second member preferably have an electromagnetic shield function for shielding the external electromagnetic noise.

A first microphone according to the present invention is a microphone in which a microphone chip is used for the sensor in the semiconductor device according to the present invention, where an acoustic perforation is opened in the first member, and the microphone chip is mounted on the first member so as to cover the acoustic perforation. According to such a first microphone, the microphone having a small mounting area can be formed, and the sensitivity of the microphone chip can be enhanced since the space in the package becomes the back chamber of the microphone chip.

A second microphone according to the present invention is a microphone in which a microphone chip is used for the sensor in the semiconductor device according to the present invention, where an acoustic perforation is opened in the first member so as not to overlap with the microphone chip. A third microphone according to the present invention is a microphone in which a microphone chip is used for the sensor in the semiconductor device according to the present invention, where an acoustic perforation is opened in the second member so as not to overlap with the circuit element. According to the second and third microphone, the microphone having a small mounting area can be formed. Furthermore, the space in the package becomes the front chamber of the microphone chip according to such microphones.

### BRIEF DESCRIPTION OF THE DRAWINGS

Fig. 1A is a bottom view of a cover on which a microphone chip is mounted according to a first embodiment of the present invention, and Fig. 1B is a plan view of a substrate on which a circuit element is mounted according to the first embodiment;
Fig. 2A is a bottom view of the cover of the first embodiment in which a solder resist is removed, and Fig. 2B is a plan view of the substrate of the first embodiment in which the solder resist is removed;
Fig. 3 is a cross-sectional view of a microphone of the first embodiment, showing a cross-section taken along an area corresponding to line X1-X1 in Fig. 1;
Fig. 4 is a cross-sectional view of the microphone of the first embodiment, showing a cross-section taken along an area corresponding to line Y1-Y1 in Fig. 1;
Fig. 5 is a cross-sectional view of the microphone of the first embodiment, showing a cross-section taken along an area corresponding to line Z1-Z1 in Fig. 1;
Fig. 6A is a view for describing another mode of a bonding pad, and Fig. 6B shows the bonding pad of Fig. 6A in which the solder resist is removed;
Fig. 7A is a view for describing still another mode of the bonding pad, and Fig. 7B shows the bonding pad of Fig. 7A in which the solder resist is removed;
Fig. 8A is a bottom view showing the cover of another mode, and Fig. 8B is a plan view showing the substrate of another mode;
Fig. 9A is a bottom view of a cover on which a microphone chip is mounted according to a second embodiment of the present invention, and Fig. 9B is a plan view of a substrate on which a circuit element is mounted according to the second embodiment;
Fig. 10 is a cross-sectional view of a microphone of the second embodiment, showing a cross-section taken along an area corresponding to line X2-X2 in Figs. 9A and 9B;
Fig. 11 is a cross-sectional view of the microphone of the second embodiment, showing a cross-section taken along an area corresponding to line Y2-Y2 in Figs. 9A and 9B;
Fig. 12A is a bottom view of a cover on which a microphone chip is mounted according to a third embodiment of the present invention, and Fig. 12B is a plan view of a substrate on which a circuit element is mounted according to the third embodiment;
Fig. 13A is a bottom view of a cover on which a microphone chip is mounted according to a fourth embodiment of the present invention, and Fig. 13B is a plan view of a substrate on which a circuit element is mounted according to the fourth embodiment;
Fig. 14A is a bottom view of the cover of the fourth embodiment in which the solder resist is removed, and Fig. 14B is a plan view of the substrate of the fourth embodiment in which the solder resist is removed;
Fig. 15 is a cross-sectional view of a microphone of the fourth embodiment, showing a cross-section taken along an area corresponding to line X4-X4 in Fig. 13;
Fig. 16 is a cross-sectional view of the microphone of the fourth embodiment, showing a cross-section taken along an area corresponding to line Y4-Y4 in Fig. 13;
Fig. 17A is a bottom view of a cover on which a microphone chip is mounted according to a fifth embodiment of the present invention, and Fig. 17B is a plan view of a substrate on which a circuit element is mounted according to the fifth embodiment;
Fig. 18 is a cross-sectional view of a microphone of the fifth embodiment, showing a cross-section taken along an area corresponding to line X5-X5 in Fig. 17;
Fig. 19 is a cross-sectional view of the microphone of the fifth embodiment, showing a cross-section taken along an area corresponding to line Y5-Y5 in Fig. 17;
Fig. 20A is a bottom view of a cover on which a microphone chip is mounted according to a sixth embodiment of the present invention, and Fig. 20B is a plan view of a substrate on which a circuit element is mounted according to the sixth embodiment;
Fig. 21A is a bottom view of a cover on which a circuit element is mounted according to a seventh embodiment of the present invention, and Fig. 21B is a plan view of a substrate on which a microphone chip is mounted according to the seventh embodiment;
Fig. 22 is a cross-sectional view of a microphone of the seventh embodiment, showing a cross-section taken along an area corresponding to line X7-X7 in Figs. 21A and 21B;
Fig. 23 is a cross-sectional view of the microphone of the seventh embodiment, showing a cross-section taken along an area corresponding to line Y7-Y7 in Figs. 21A and 21B;
Fig. 24A is a plan view of a substrate on which a microphone chip is mounted according to an eighth embodiment of the present invention, and Fig. 24B is a cross-sectional view of a microphone of the eighth embodiment, showing a cross-section taken along an area corresponding to line X8-X8 in Fig. 24A;
Fig. 25A is a bottom view of a cover on which a circuit element is mounted according to a ninth embodiment of the present invention, and Fig. 25B is a cross-sectional view of a microphone of the ninth embodiment, showing a cross-section taken along an area corresponding to line X9-X9 in Fig. 25A;
Fig. 26A is a bottom view of a cover on which a circuit element is mounted according to a tenth embodiment of the present invention, and Fig. 26B is a plan view of a substrate on which a microphone chip is mounted according to the tenth embodiment;
Fig. 27A is a cross-sectional view of a microphone according to the tenth embodiment, showing a cross-section taken along an area corresponding to line X10-X10 in Figs. 26A and 26B, and Fig. 27B is a cross-sectional view of the microphone of the tenth embodiment, showing a cross-section taken along an area corresponding to line Y10-Y10 in Figs. 26A and 26B;
Fig. 28A is a plan view of a substrate on which a microphone chip is mounted according to an eleventh embodiment of the present invention, and Fig. 28B is a cross-sectional view of a microphone of the eleventh embodiment, showing a cross-section taken along an area corresponding to line X11-X11 in Fig. 28A;
Fig. 29A is a bottom view of a cover on which a circuit element is mounted according to a twelfth embodiment of the present invention, and Fig. 29B is a cross-sectional view of a microphone of the twelfth embodiment, showing a cross-section taken along an area corresponding to line X12-X12 in Fig. 29A;
Fig. 30A is a bottom view of a cover on which a microphone chip is mounted according to a thirteenth embodiment of the present invention, and Fig. 30B is a plan view of a substrate on which a circuit element is mounted according to the thirteenth embodiment;
Fig. 31A is a cross-sectional view of a microphone according to the thirteenth embodiment, showing a cross-section taken along an area corresponding to line X13-X13 in Figs. 30A and 30B, and Fig. 31B is a cross-sectional view of the microphone of the thirteenth embodiment, showing a cross-section taken along an area corresponding to line Y13-Y13 in Figs. 30A and 30B;
Fig. 32 is a cross-sectional view of a microphone according to a fourteenth embodiment of the present invention; and
Fig. 33 is a cross-sectional view of a microphone according to a fifteenth embodiment of the present invention.

### DETAILED DESCRIPTION

### (First Embodiment)

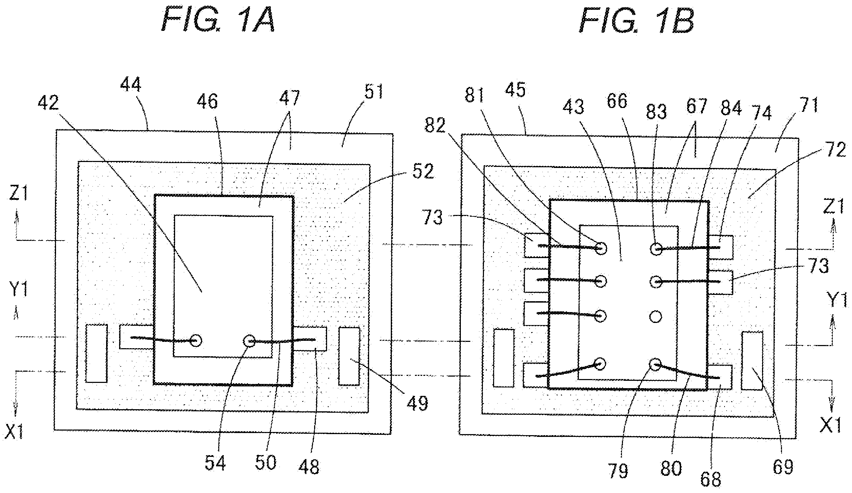

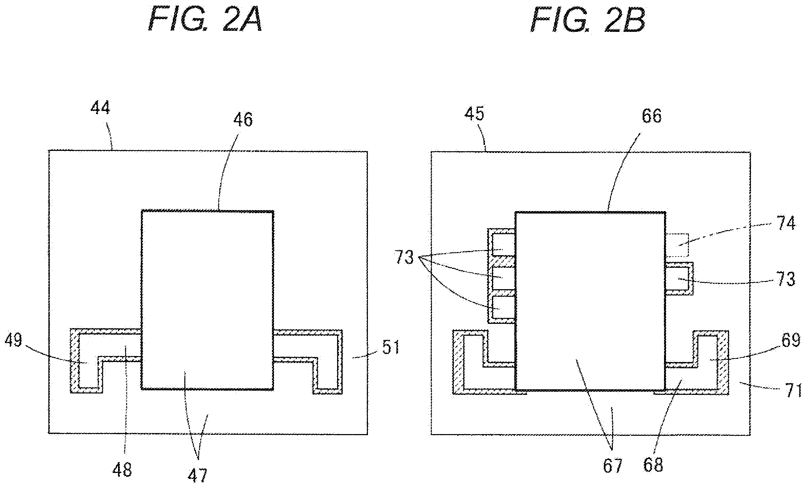

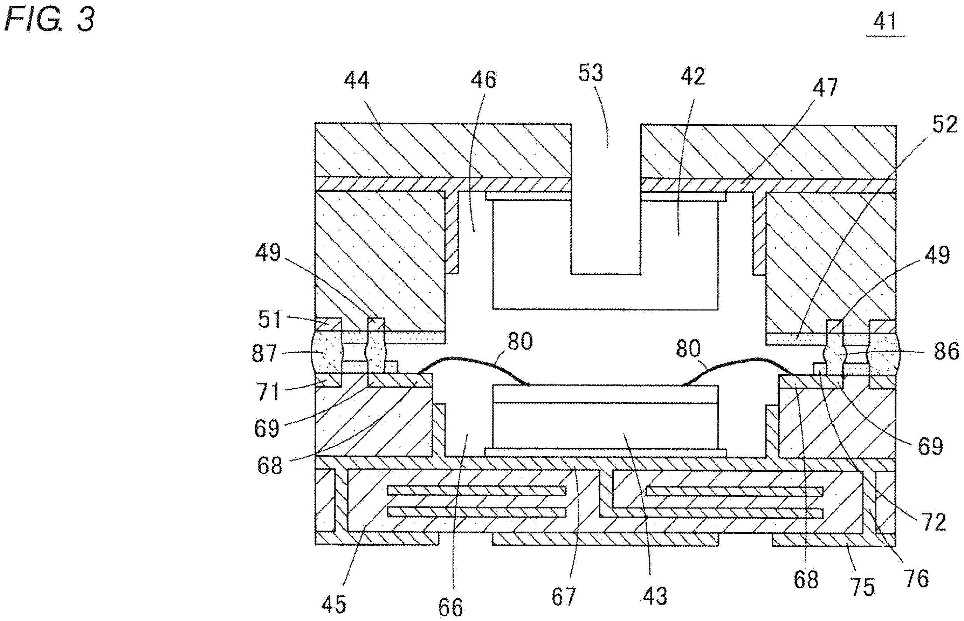

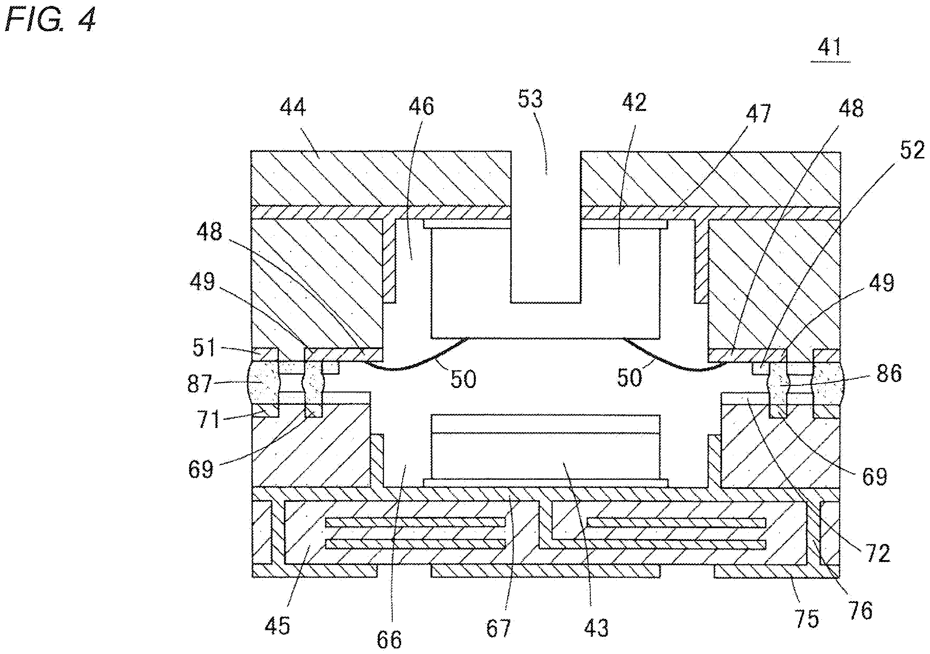

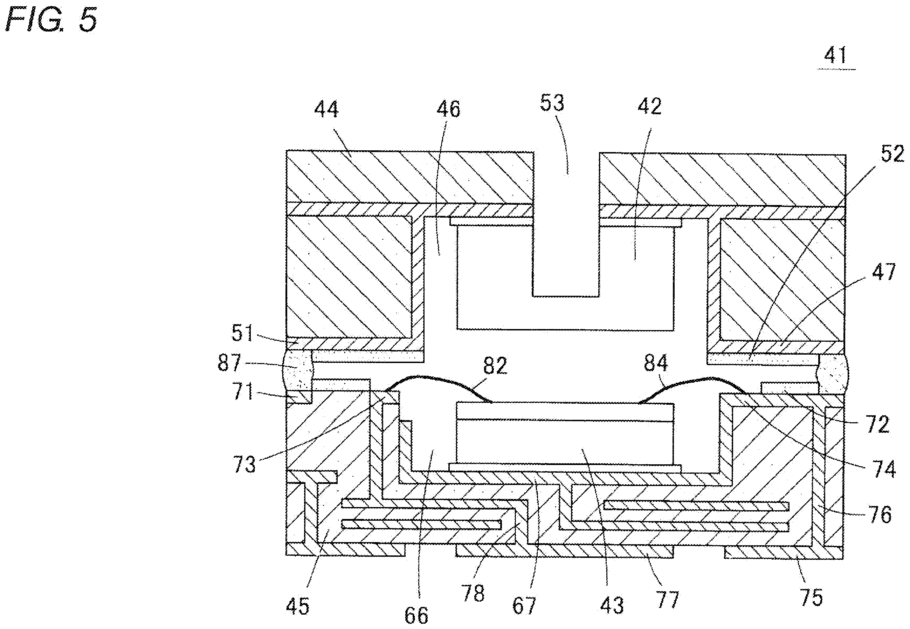

A top port type microphone 41 according to a first embodiment of the present invention will be described with reference to Figs. 1A and 1B to Fig. 4. The microphone 41 is a MEMS microphone manufactured using the MEMS technique, where a microphone chip 42 (sensor) and a circuit element 43 are accommodated in a package formed by a cover 44 (first member) and a substrate 45 (second member). The microphone 41 of the first embodiment is a top port type in which an acoustic perforation 53 is opened in the cover 44. Fig. 1A is a bottom view of the cover 44 on which the microphone chip 42 is mounted, and Fig. 1B is a plan view of the substrate 45 on which the circuit element 43 is mounted. Fig. 2A is a bottom view of the cover 44 in which a solder resist is removed, and Fig. 2B is a plan view of the substrate 45 in which the solder resist is removed. Fig. 3 is a cross-sectional view of the microphone 41 taken along an area corresponding to line X1-X1 in Fig. 1. Fig. 4 is a cross-sectional view of the microphone 41 taken along an area corresponding to line Y1-Y1 in Fig. 1. Fig. 5 is a cross-sectional view of the microphone 41 taken along an area corresponding to line Z1-Z1 in Fig. 1.

As shown in Fig. 3 to Fig. 5, the cover 44 is configured by stacking two insulating substrates including at least one material of a copper laminated stacked plate or from a glass epoxy, ceramic, plastic, metal, or carbon nano tube or a complex material thereof. The cover 44 formed from an insulating material includes a box-shaped recess 46 for accommodating the microphone chip 42. A conductive layer 47 for electromagnetic shield is formed substantially entirely on the top surface and the side wall surface of the recess 46 and the lower surface of the side wall portion surrounding the recess 46. The conductive layer 47 formed on the top surface of the cover 44 is extended to the interior of the insulating material.

As shown in Fig. 1A, the exterior of the recess 46, that is, the lower surface of the cover 44 is covered by a solder resist 52, and a plurality of bonding pads 48 (first bonding pad) and cover side joining portions 49 (first joining portion) are arranged at the lower surface of the cover 44 so as to be exposed from the solder resist 52. The outer peripheral part of the conductive layer 47 is exposed from the solder resist 52 to become a ground joining portion 51.

The conductive layer 47, the bonding pad 48, and the cover side joining portion 49 are metal films, but the periphery of the bonding pad 48 and the cover side joining portion 49 is separated from the conductive layer 47, and each bonding pad 48 and cover side joining portion 49 is electrically insulated from the conducive layer 47, as shown in Fig. 2A. On the other hand, as shown in Fig. 2A, the bonding pad 48 and the cover side joining portion 49 are connected to each other under the solder resist 52 and are electrically conducted. The hatched area in Fig. 2A is the portion where the metal film is removed and the insulating material of the cover 44 is exposed.

The microphone chip 42 is a MEMS element (acoustic sensor), where a thin film diaphragm for acoustic vibration sensing is arranged at the opening of the Si substrate and a canopy shaped back plate is fixed to the Si substrate while facing the diaphragm. A fixed electrode film arranged on the back plate and the diaphragm (both of which are made of polysilicon) configure a capacitor for detection signal output, and a great number of acoustic holes for guiding the acoustic vibration to an air gap between the fixed electrode film and the diaphragm are opened in the back plate. As shown in Figs. 3 to 5, the microphone chip 42 is accommodated in the recess 46, and has the back surface fixed to the top surface (conductive layer 47) of the recess 46 by an adhesive. The microphone chip 42 is installed in accordance with the acoustic perforation 53 formed in the cover 44 to cover the acoustic perforation 53. Therefore, the microphone chip 42 can have a wide back chamber volume since the opening of the Si substrate and the acoustic perforation 53 become the front chamber and a space in the package becomes the back chamber, whereby the microphone chip 42 can have higher sensitivity. As shown in Fig. 1A and Fig. 4, a terminal 54 provided on the front surface of the microphone chip 42 is connected to the bonding pad 48 by a bonding wire 50 (first wire wiring).

As shown in Fig. 3 to Fig. 5, the substrate 45 is formed by a multi-layered wiring substrate, a copper laminated stacked plate, a glass epoxy substrate, a ceramic substrate, a plastic substrate, a metal substrate, a carbon nano tube substrate, or a compound substrate thereof. The substrate 45 includes a box-shaped recess 66 for accommodating the circuit element 43. A conductive layer 67 for electromagnetic shield is formed substantially entirely over the bottom surface and the side wall surface of the recess 66 and the upper surface of the side wall portion surrounding the recess 66.

As shown in Fig. 1B, the exterior of the recess 66, that is, the upper surface of the substrate 45 is covered by a solder resist 72, and a plurality of bonding pads 68 (second bonding pad), bonding pads 73, 74 and a substrate side joining portions 69 (second joining portion) are arranged at the lower surface of the substrate 45 so as to be exposed from the solder resist 52. The outer peripheral part of the conductive layer 67 is exposed from the solder resist 72 to become a ground joining portion 71 . The bonding pad 68 is a pad for connecting the circuit element 43 to the microphone chip 42, the bonding pad 73 is a pad for connecting the circuit element 43 to a signal input/output terminal 77 at the lower surface, and the bonding pad 74 is a ground connection pad.

The conductive layer 67, the bonding pads 68, 73, 74, and the substrate side joining portion 69 are metal films, but the periphery of the bonding pad 68 and the substrate side joining portion 69 and the bonding pad 73 is separated from the conductive layer 67 respectively, and each bonding pad 68 and substrate side joining portion 69 and the bonding pad 73 is electrically insulated from the conducive layer 67, as shown in Fig. 2B. On the other hand, as shown in Fig. 2B, the bonding pad 68 and the substrate side joining portion 69 are connected to each other under the solder resist 72 and are electrically conducted. The bonding pad 74 is one part of the conductive layer 67 and is conducted to the ground joining portion 71. The hatched area in Fig. 2B is the portion where the metal film is removed and the insulating material of the substrate 45 is exposed.

A ground terminal 75 is provided at the lower surface of the substrate 45, which ground terminal 75 is connected to the conductive layer 67 through a via hole 76. Therefore, a ground terminal 83 of the circuit element 43 is conducted to the ground terminal 75 through the via hole 76, or the like. A signal input/output terminal 77 for signal input/output is provided at the lower surface of the substrate 45, which signal input/output terminal 77 is connected to the bonding pad 73 through a via hole 78. Therefore, a terminal 81 of the circuit element 43 is conducted to the signal input/output terminal 77 through the via hole 78, or the like.

The circuit element 43 is an element such as an ASIC or an IC chip. As shown in Fig. 3 to Fig. 5, the circuit element 43 is accommodated in the recess 66, and has the back surface fixed to the bottom surface of the recess 66 with an adhesive.

As shown in Fig. 1B, a terminal 79 for microphone chip connection provided at the front surface of the circuit element 43 is connected to the bonding pad 68 by a bonding wire 80 (second wire wiring). A terminal 81 for signal input/output provided at the front surface of the circuit element 43 is connected to the bonding pad 73 by a bonding wire 82. Furthermore, a ground terminal 83 provided at the front surface of the circuit element 43 is connected to the bonding pad 74 by a bonding wire 84.

As shown in Figs. 3 to 5, the cover 44 is overlapped on the upper surface of the substrate 45 with the recess 46 facing the lower side, and the opposing cover side joining portion 49 and the substrate side joining portion 69 are joined with a conductive material 86. The conductive material 86 may be one of a conductive adhesive or solder, a conductive double-sided adhesive tape, or wax material for welding, or a plurality of materials thereof may be simultaneously used. The ground joining portion 51 arranged at the outer peripheral part of the lower surface of the cover 44 and the ground joining portion 71 arranged at the outer peripheral part of the upper surface of the substrate 45 are joined over the entire periphery by a conductive material 87. The conductive material 87 may be one of a conductive adhesive or solder, a conductive double-sided adhesive tape, or wax material for welding, or a plurality of materials thereof may be simultaneously used. A non-conductive resin or a non-conductive tape may be simultaneously used to laminate the cover 44 and the substrate 45.

As a result, the microphone chip 42 and the circuit element 43 are accommodated in the package formed by the cover 44 and the substrate 45. The conductive layer 47 of the cover 44 is electrically conducted with the conductive layer 67 of the substrate 45 by joining the ground joining portion 51 and the ground joining portion 71 with the conductive material 87, and hence the conductive layers 47 and 67 are held at ground potential by connecting the ground terminal 75 to the earth line of the circuit substrate, or the like and the microphone 41 is shielded from the external electromagnetic noise. Furthermore, since the cover side joining portion 49 and the substrate side joining portion 69 are joined through the conductive material 86, the microphone chip 42 is connected to the terminal 79 of the circuit element 43 through a path of the bonding wire 50 → bonding pad 48 → cover side joining portion 49 → conductive material 86 → substrate side joining portion 69 → bonding pad 68 → bonding wire 80.

In the microphone 41 having such a structure, the microphone chip 42 is mounted on the cover 44, the circuit element 43 is mounted on the substrate 45, and the microphone chip 42 is arranged so as to be overlapped immediately above the circuit element 43, and thus the package having a small bottom area can be used. As a result, the microphone 41 having an extremely small mounting area can be produced.

In the microphone 41, the bonding wire 50 from the microphone chip 42 is connected to the bonding pad 48 arranged at the lower surface of the cover 44, the bonding wire 80 from the circuit element 43 is connected to the bonding pad 68 arranged at the upper surface of the substrate 45, and the cover side joining portion 49 and the substrate side joining portion 69 are joined with the conductive material 86 when joining the cover 44 to the substrate 45, so that the microphone chip 42 and the circuit element 43 are electrically conducted. According to such a microphone 41, the bonding pad 48 will be positioned on the front surface of the cover 44 by flipping over the cover 44 so that the bonding pad 48 is on the upper side, and hence the bonding wire 50 can be easily connected to the bonding pad 48 and the terminal 54 of the microphone chip 42 using the wire bonder. Similarly, since the bonding pad 68 is positioned on the upper surface of the substrate 45, the bonding wire 80 can be easily connected to the bonding pad 68 and the terminal 79 of the circuit element 43 using the wire bonder.

Therefore, in the microphone 41, the microphone chip 42 on the cover 44 and the circuit element 43 on the substrate 45 can be electrically connected by a simple wiring structure and a simple assembly method. Furthermore, as the connection task of the bonding wire does not need to be carried out inside the recesses 46, 66, the wire connecting task of the bonding wires 50, 80 is facilitated, and furthermore, the bottom area of the package does not become large and the mounting area of the microphone 41 can be reduced since a space for inserting the jig for wire bonding is not necessary in the recesses 46, 66 as in the microphone disclosed in US Patent Application Publication No. 2008/0283988. Moreover, the cost of the microphone 41 can be reduced since the bonding pads 48, 68, the cover side joining portion 49, and the substrate side joining portion 69 are formed using a metal film for electromagnetic shield. Furthermore, the thickness of the side wall portion of the cover 44 and the substrate 45 does not increase, and the mounting area of the microphone 41 does not increase due to the side wall portion as with the microphone disclosed in US Patent Application Publication No. 2008/0058826.

### (Variants)

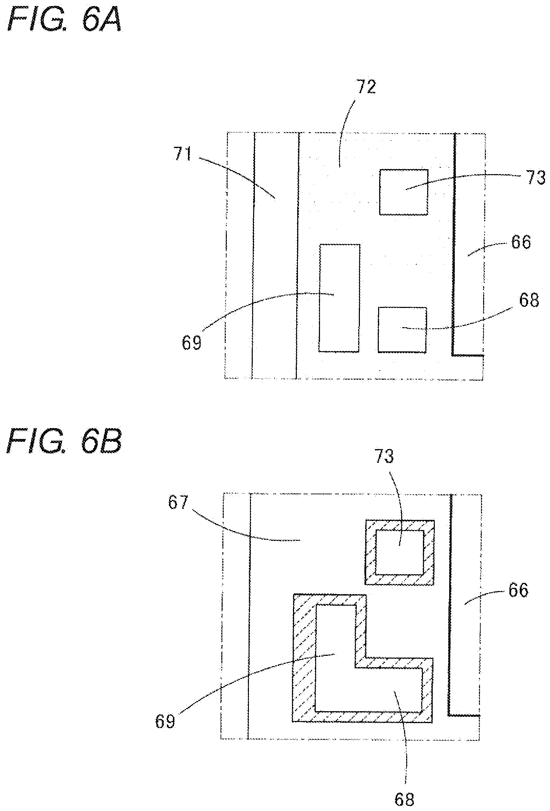

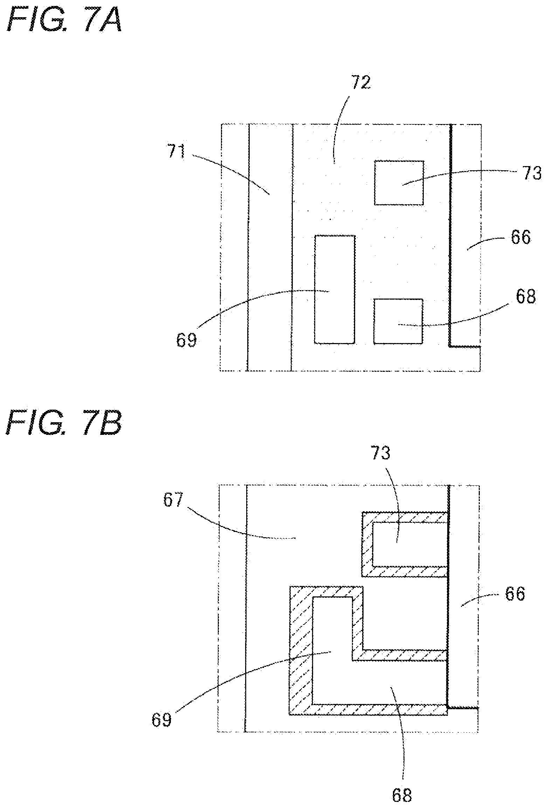

In the microphone 41 of the first embodiment, the bonding pads 68, 73, 74 are arranged to contact the edge of the recess 66, but the bonding pads 68, 73, 74 may be arranged spaced apart from the edge of the recess 66, as shown in Fig. 6A or Fig. 7A. In this case, the electrode film configuring the bonding pads 68, 73, 74 may be spaced apart from the recess 66 as shown in Fig. 6B or may be extended up to the edge of the recess 66 under the solder resist 72 as shown in Fig. 7B. Similarly, the bonding pad 48 of the cover 44 may also be arranged to be spaced apart from the edge of the recess 46.

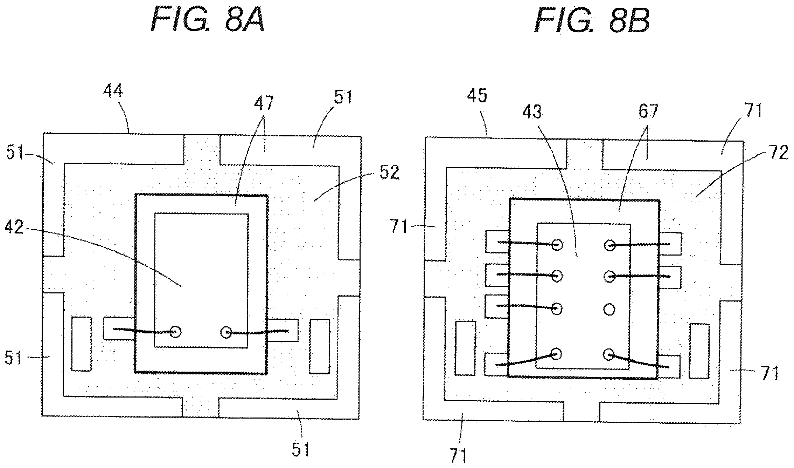

The ground joining portion 51 and the ground joining portion 71 do not need to be arranged over the entire periphery of the cover 44 and the substrate 45, and may be partially divided, as shown in Fig. 8A and Fig. 8B. In this case, the conductive layers 47, 67 may exist or may not exist under the solder resists 52, 72 dividing the ground joining portion 51 and the ground joining portion 71 .

Such variants are applied not only to the first embodiment but may also be applied to second and subsequent embodiments.

### (Second Embodiment)

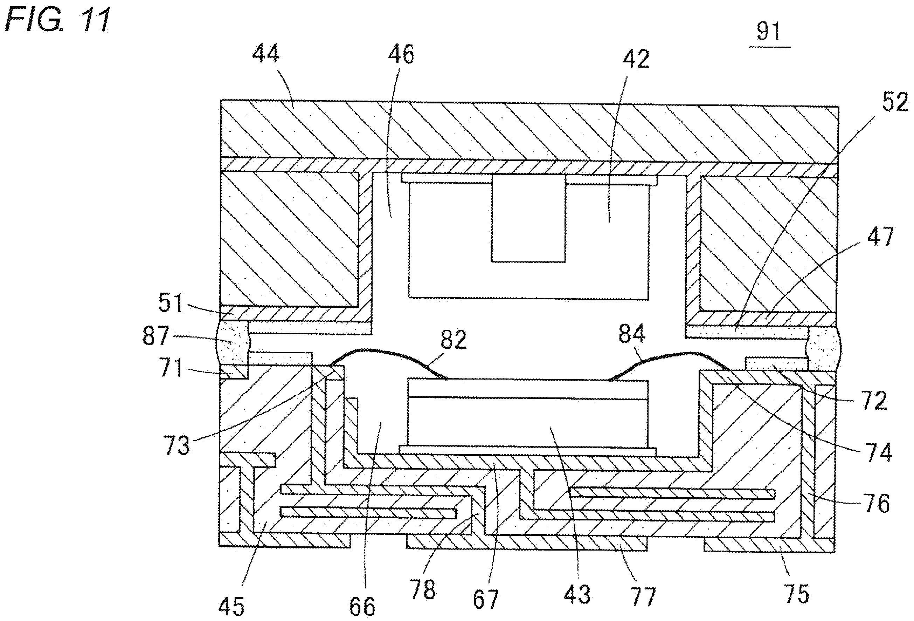

A top port type microphone 91 of a second embodiment will now be described with reference to Figs. 9A and 9B to Fig. 11. Fig. 9A is a bottom view of the cover 44 on which the microphone chip 42 is mounted, and Fig. 9B is a plan view of the substrate 45 on which the circuit element 43 is mounted. Fig. 10 is a cross-sectional view of the microphone 91 taken along an area corresponding to line X2-X2 in Figs. 9A and 9B. Fig. 11 is a cross-sectional view of the microphone 91 taken along an area corresponding to line Y2-Y2 in Figs. 9A and 9B. The present embodiment has substantially the same structure as the first embodiment, and hence the same reference numerals as the first embodiment will be denoted for the portions of the same structure in the drawings and the description thereof will be omitted (same for third and subsequent embodiments).

In the microphone 91, the acoustic perforation 53 is opened at a position not overlapping with the microphone chip 42 in the recess 46 of the cover 44. Therefore, in the microphone 91, the internal space of the package becomes the front chamber and the opening of the Si substrate becomes the back chamber, so that the microphone chip 42 has the diaphragm vibrated by the acoustic vibration that reached from the opposite side of the case of the first embodiment.

### (Third Embodiment)

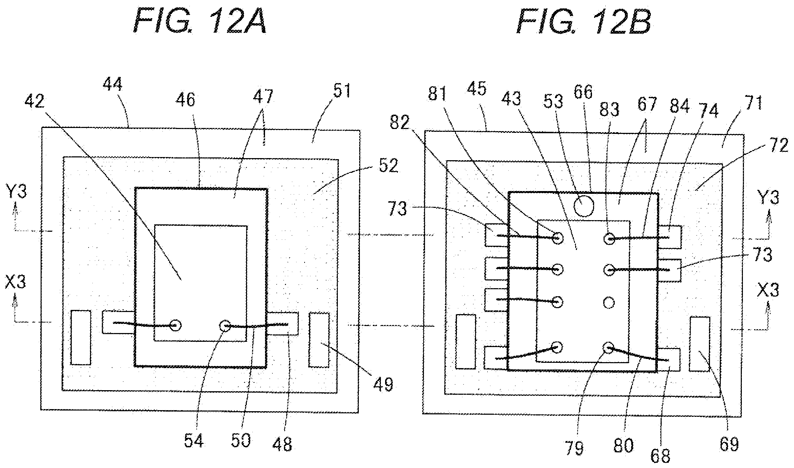

Figs. 12A and 12B are views each for describing a bottom port type microphone according to a third embodiment of the present invention, where Fig. 12A is a bottom view of the cover 44 on which the microphone chip 42 is mounted, and Fig. 12B is a plan view of the substrate 45 on which the circuit element 43 is mounted. The cross section of the microphone of the third embodiment taken along an area corresponding to line X3-X3 in Figs. 12A and 12B is the same as Fig. 10, and the cross section of the microphone of the third embodiment taken along an area corresponding to line Y3-Y3 in Figs. 12A and 12B is the same as Fig. 11.

In the microphone of the third embodiment, the acoustic perforation 53 is opened at a position not overlapping with the circuit element 43 in the recess 66 of the substrate 45, and thus is a bottom port type. Therefore, in this microphone as well, the internal space of the package becomes the front chamber and the opening of the Si substrate becomes the back chamber, so that the microphone chip 42 has the diaphragm vibrated by the acoustic vibration that reached from the opposite side of the case of the first embodiment.

### (Fourth Embodiment)

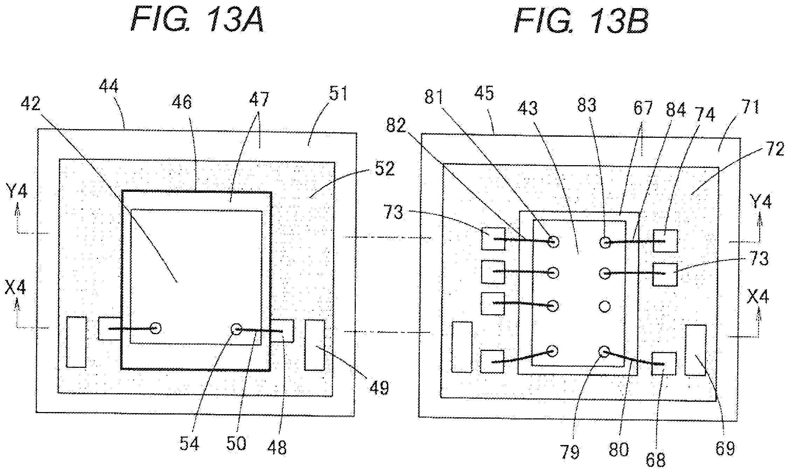

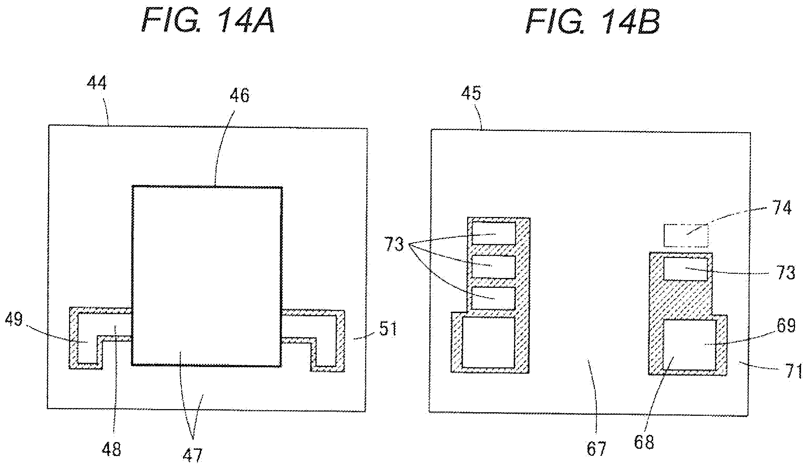

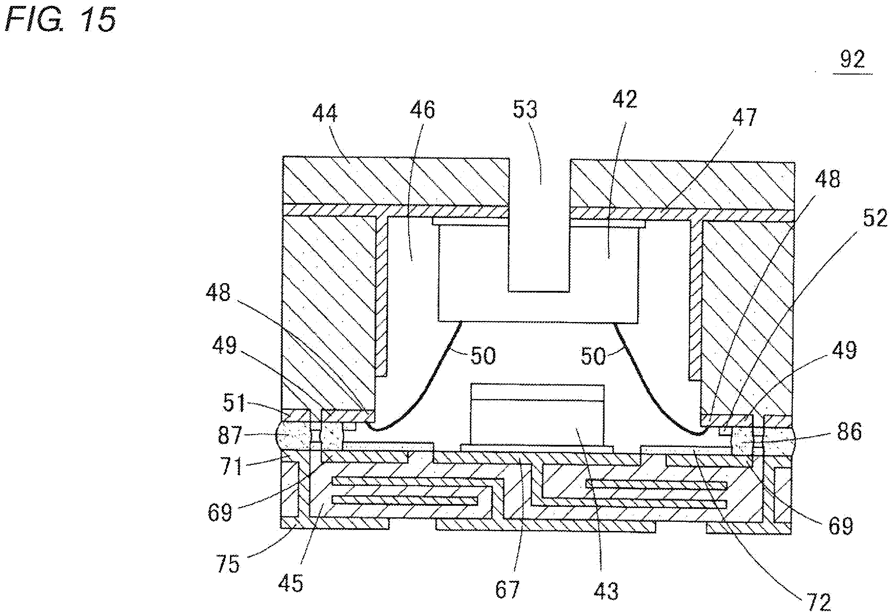

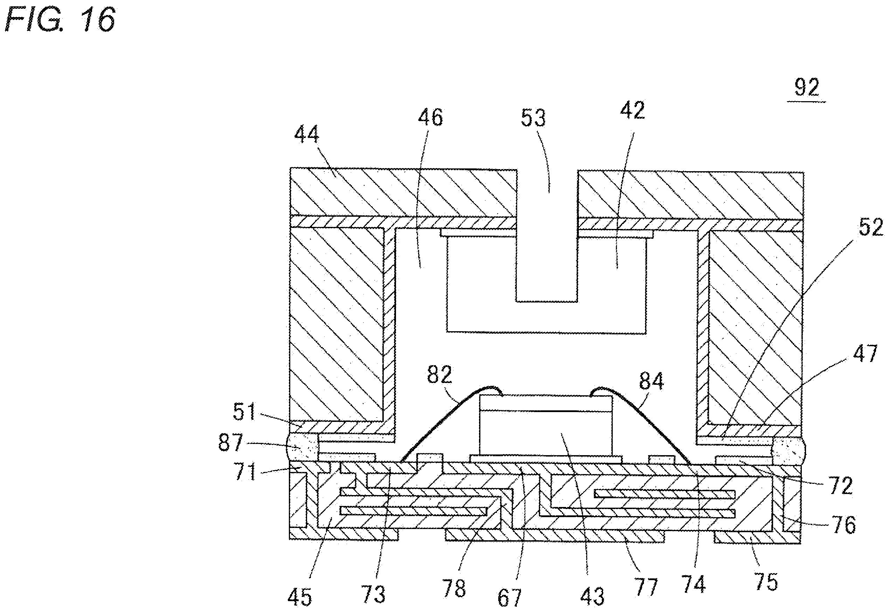

A top port type microphone 92 according to a fourth embodiment of the present invention will now be described. Fig. 13A is a bottom view of the cover 44 on which the microphone chip 42 is mounted, and Fig. 13B is a plan view of the substrate 45 on which the circuit element 43 is mounted. Fig. 14A is a bottom view of the cover 44 in which the solder resist is removed, and Fig. 14B is a plan view of the substrate 45 in which the solder resist is removed. Fig. 15 is a cross-sectional view of the microphone 92 taken along an area corresponding to line X4-X4 in Fig. 13. Fig. 16 is a cross-sectional view of the microphone 92 taken along an area corresponding to line Y4-Y4 in Fig. 13.

The microphone 92 of the fourth embodiment uses the flat plate shaped substrate 45 without the recess 66. The cover 44 on which the microphone chip 42 is mounted has the same structure as the first embodiment. As shown in Fig. 14B, a flat plate shaped metal film is arranged on the upper surface of the substrate 45, where such a metal film is partially removed to form a region for forming the conductive layer 67, the bonding pad 68, and the substrate side joining portion 69, and the bonding pads 73, 74. The upper surface of the substrate 45 is covered with the solder resist 72 to frame like, so that the ground joining portion 71 is formed at the outer peripheral part and the region for mounting the circuit element 43 is formed on the inner side, as shown in Fig. 13B. The bonding pad 68, the substrate side joining portion 69, and the bonding pads 73, 74 are formed by being exposed from the solder resist 72.

As shown in Fig. 15 and Fig. 16, in the microphone 92 in which the cover 44 and the substrate 45 are overlapped, the ground joining portion 51 and the ground joining portion 71 are joined by the conductive material 87 at the upper surface of the substrate 45. The cover side joining portion 49 and the substrate side joining portion 69 are joined by the conductive material 86 at the upper surface of the substrate 45, so that the microphone chip 42 and the circuit element 43 are connected. In such a microphone 92, the space in the package becomes the back chamber of the microphone chip 42.

### (Fifth Embodiment)

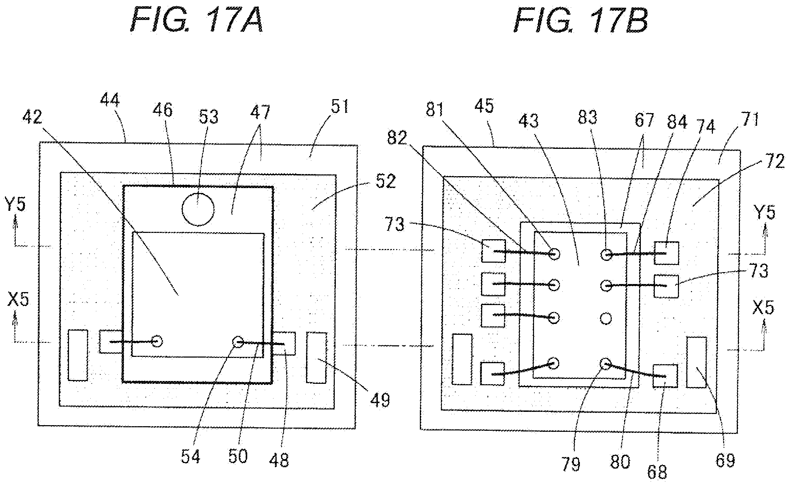

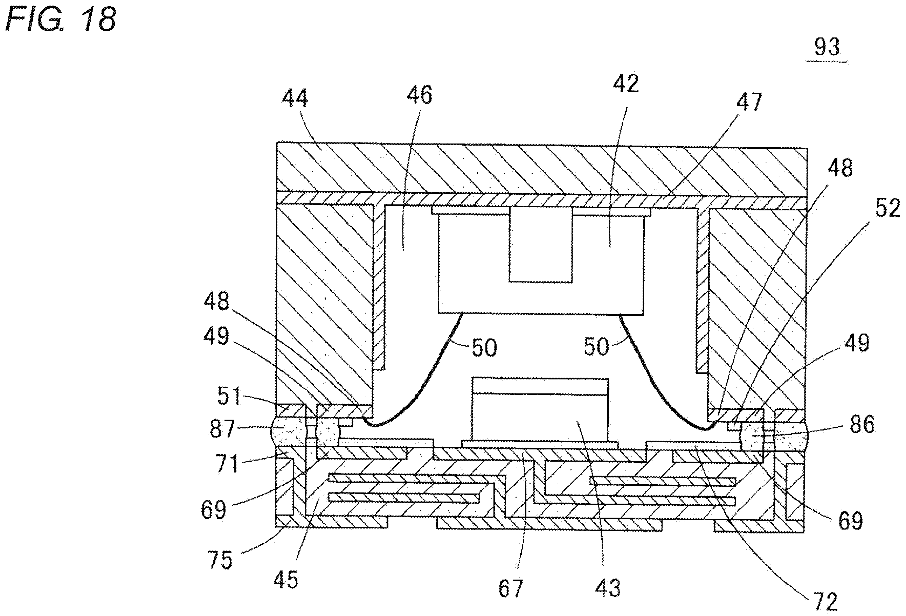

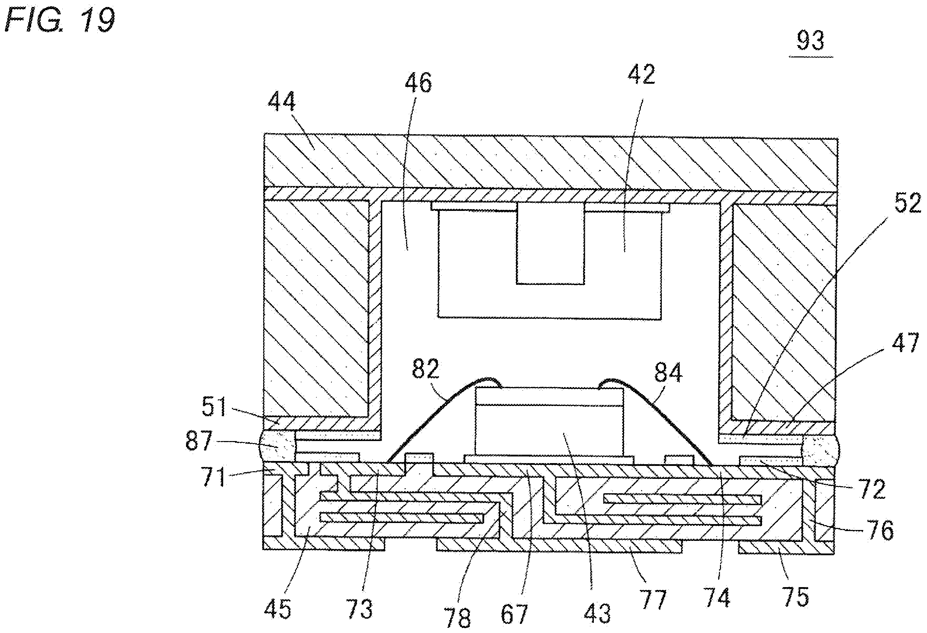

Figs. 17A and 17B to Fig. 19 describe a top port type microphone 93 according to a fifth embodiment of the present invention. Fig. 17A is a bottom view of the cover 44 on which the microphone chip 42 is mounted, and Fig. 17B is a plan view of the substrate 45 on which the circuit element 43 is mounted. Fig. 18 is a cross-sectional view of the microphone 93 taken along an area corresponding to line X5-X5 in Fig. 17. Fig. 19 is a cross-sectional view of the microphone 93 taken along an area corresponding to line Y5-Y5 in Fig. 17.

The microphone 93 has the circuit element 43 and the microphone chip 42 accommodated in the package formed by the flat plate shaped substrate 45 and the cover 44 with the recess 46, where the microphone chip 42 is arranged immediately above the circuit element 43. The acoustic perforation 53 is arranged in the recess 46 of the cover 44 at a position not overlapping with the microphone chip 42. Therefore, the space in the package becomes the front chamber of the microphone chip 42.

### (Sixth Embodiment)

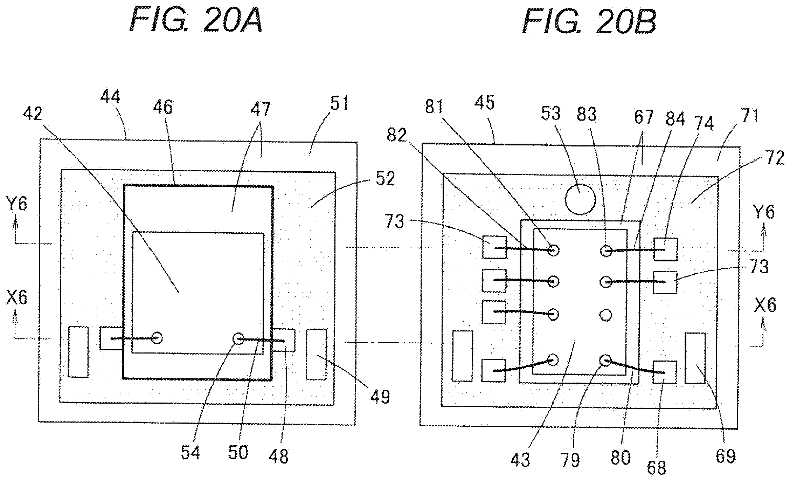

Figs. 20A and 20B are views each for describing a bottom port type microphone according to a sixth embodiment of the present invention, where Fig. 20A is a bottom view of the cover 44 on which the microphone chip 42 is mounted, and Fig. 20B is a plan view of the substrate 45 on which the circuit element 43 is mounted. The cross-section of the microphone of the sixth embodiment taken along an area corresponding to line X6-X6 in Fig. 20 is the same as Fig. 18, and the cross-section of the microphone of the sixth embodiment taken along an area corresponding to line Y6-Y6 in Fig. 20 is the same as Fig. 19.

The microphone has the circuit element 43 and the microphone chip 42 accommodated in the package formed by the flat plate shaped substrate 45 and the cover 44 with the recess 46, where the microphone chip 42 is arranged immediately above the circuit element 43. The acoustic perforation 53 is arranged in the substrate 45 at a position not overlapping with the circuit element 43. Therefore, the space in the package becomes the front chamber of the microphone chip 42.

### (Seventh Embodiment)

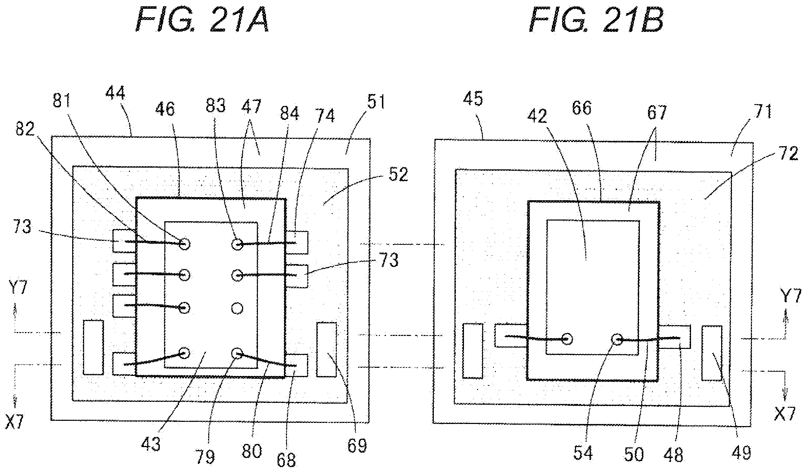

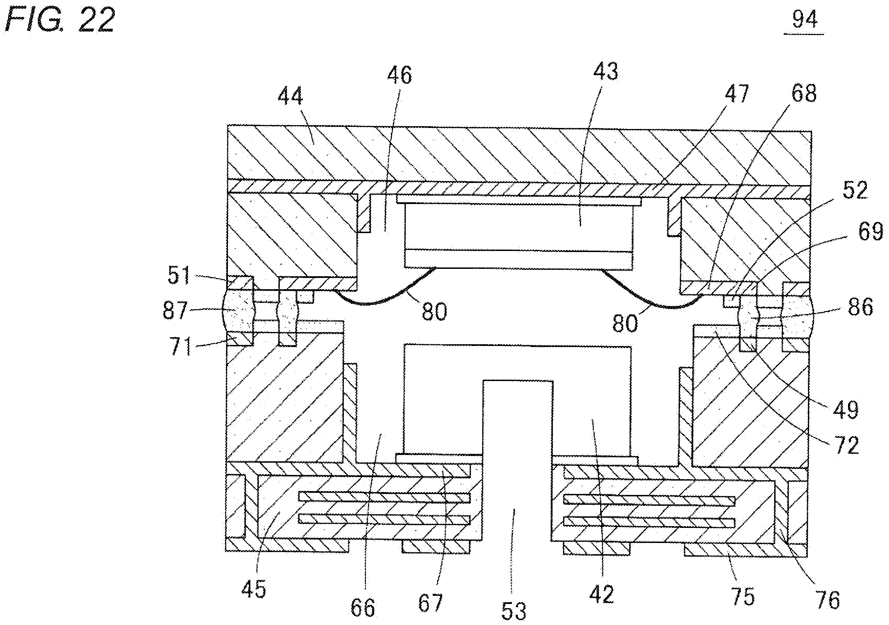

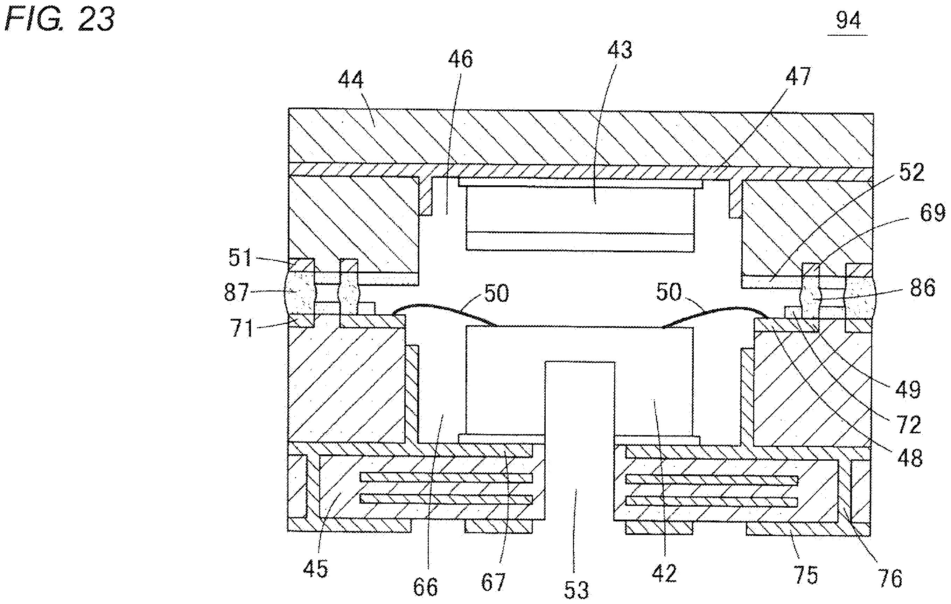

Figs. 21A and 21B to Fig. 23 describe a bottom port type microphone 94 according to a seventh embodiment of the present invention. Fig. 21A is a bottom view of the cover 44 on which the circuit element 43 is mounted (the cover 44 corresponds to the second member if the circuit element 43 is mounted on the cover 44), and Fig. 21B is a plan view of the substrate 45 on which the microphone chip 42 is mounted (the substrate 45 corresponds to the first member if the microphone chip 42 is mounted on the substrate 45). Fig. 22 is a cross-sectional view of the microphone 94 taken along an area corresponding to line X7-X7 in Figs. 21A and 21B. Fig. 23 is a cross-sectional view of the microphone 94 taken along an area corresponding to line Y7-Y7 in Fig. 21.

In the microphone 94, the circuit element 43 is mounted on the cover 44, the microphone chip 42 is mounted on the substrate 45, and the circuit element 43 is arranged immediately above the microphone chip 42.

As shown in Fig. 21A, the bonding pads 68, 73, 74 for connecting to the circuit element 43 and the substrate side joining portion 69 are arranged on the lower surface of the side wall portion of the cover 44. The terminal 79 of the circuit element 43 is connected to the bonding pad 68 by the bonding wire 80, the terminal 81 is connected to the bonding pad 73 by the bonding wire 82, and the ground terminal 83 is connected to the bonding pad 74 by the bonding wire 84. As shown in Fig. 21B, the bonding pad 48 for connecting to the microphone chip 42 and the cover side joining portion 49 are arranged at the upper surface of the side wall portion of the substrate 45. The terminal 54 of the microphone chip 42 is connected to the bonding pad 48 by the bonding wire 50.

As shown in Fig. 22 and Fig. 23, the cover 44 and the substrate 45 have the ground joining portion 51 and the ground joining portion 71 joined by the conductive material 87 by being overlapped one over the other. The substrate side joining portion 69 of the cover 44 and the cover side joining portion 49 of the substrate 45 are joined with the conductive material 86, so that the circuit element 43 and the microphone chip 42 are connected. The acoustic perforation 53 is opened in the substrate 45 so as to coincide with the opening of the microphone chip 42 to become the bottom port type, and the space in the package is the back chamber of the microphone chip 42.

### (Eighth Embodiment)

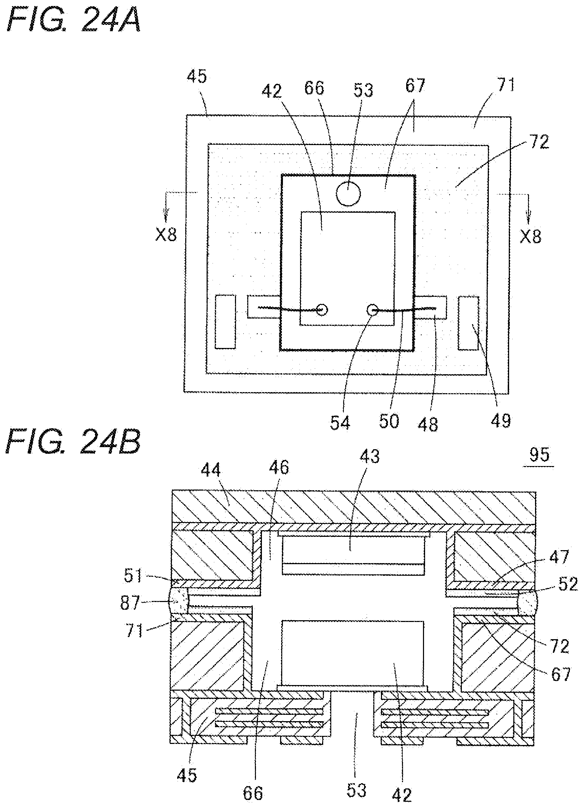

A microphone 95 according to an eighth embodiment of the present invention has the acoustic perforation 53 arranged in the vicinity of the microphone chip 42 in the bottom port type microphone. Fig. 24A is a plan view of the substrate 45 on which the microphone chip 42 is mounted in the microphone 95, and Fig. 24B is a cross-sectional view of the microphone 95 taken along an area corresponding to line X8-X8 in Fig. 24A.

In such a microphone 95, the microphone chip 42 is mounted in the recess 66 of the substrate 45, and the acoustic perforation 53 is opened at a position not overlapping with the microphone chip 42 in the recess 66. Therefore, the microphone 95 is a bottom port type, and the space in the package is the front chamber of the microphone chip 42.

### (Ninth Embodiment)

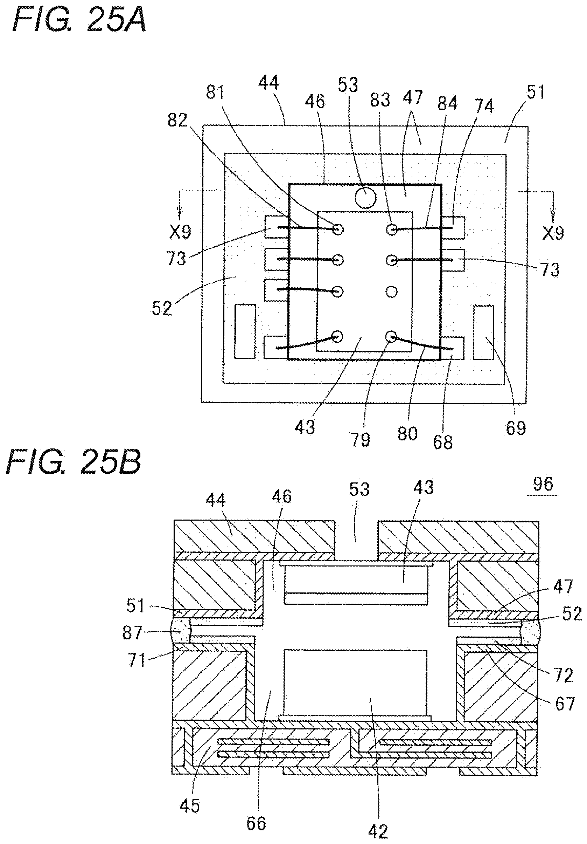

A microphone 96 according to a ninth embodiment of the present invention has the acoustic perforation 53 arranged in the vicinity of the circuit element 43 in the top port type microphone. Fig. 25A is a bottom view of the cover 44 on which the circuit element 43 is mounted in the microphone 96, and Fig. 25B is a cross-sectional view of the microphone 96 taken along an area corresponding to line X9-X9 in Fig. 25A.

In the microphone 96, the circuit element 43 is mounted in the recess 46 of the cover 44, and the acoustic perforation 53 is opened at a position not overlapping with the circuit element 43 in the recess 46. The microphone chip 42 is mounted on the upper surface of the substrate 45. Therefore, the microphone 96 is a top port type, and the space in the package is the front chamber of the microphone chip 42.

### (Tenth Embodiment)

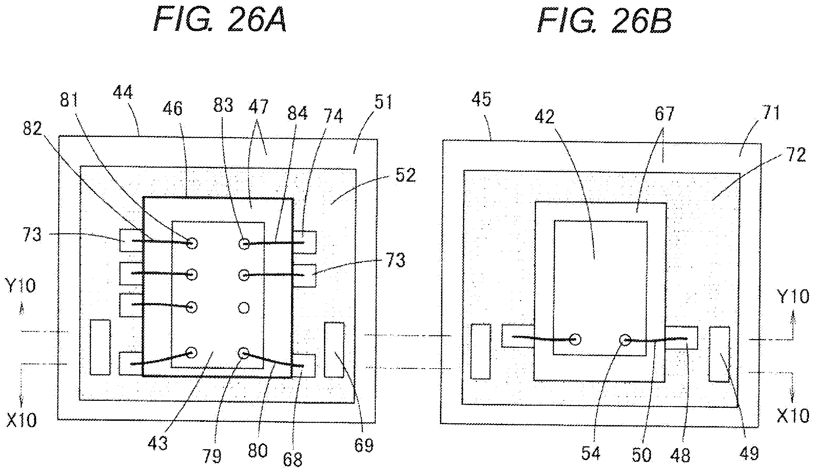

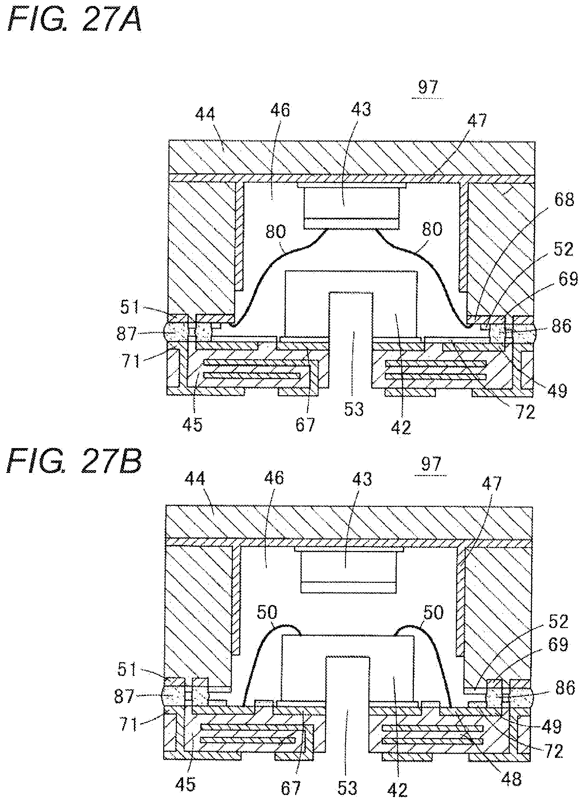

A microphone 97 according to a tenth embodiment of the present invention will now be described. Fig. 26A is a bottom view of the cover 44 on which the circuit element 43 is mounted, and Fig. 26B is a plan view of the substrate 45 on which the microphone chip 42 is mounted. Fig. 27A is a cross-sectional view of the microphone 97 taken along an area corresponding to line X10-X10 in Figs. 26A and 26B. Fig. 27B is a cross-sectional view of the microphone 97 taken along an area corresponding to line Y10-Y10 in Figs. 26A and 26B.

In the microphone 97, the circuit element 43 is mounted in the recess 46 of the cover 44, the microphone chip 42 is mounted on the upper surface of the flat plate shaped substrate 45, and the acoustic perforation 53 is opened in the substrate 45 at a position overlapping with the microphone chip 42. The circuit element 43 and the bonding pad 68 are connected through the bonding wire 80, the microphone chip 42 and the bonding pad 48 are connected through the bonding wire 50, and the substrate side joining portion 69 and the cover side joining portion 49 are joined by the conductive material 86 thereby connecting the circuit element 43 and the microphone chip 42. The microphone 97 has the acoustic perforation 53 opened at the lower surface of the microphone chip 42 and thus is a bottom port type, and the space in the package is the back chamber.

### (Eleventh Embodiment)

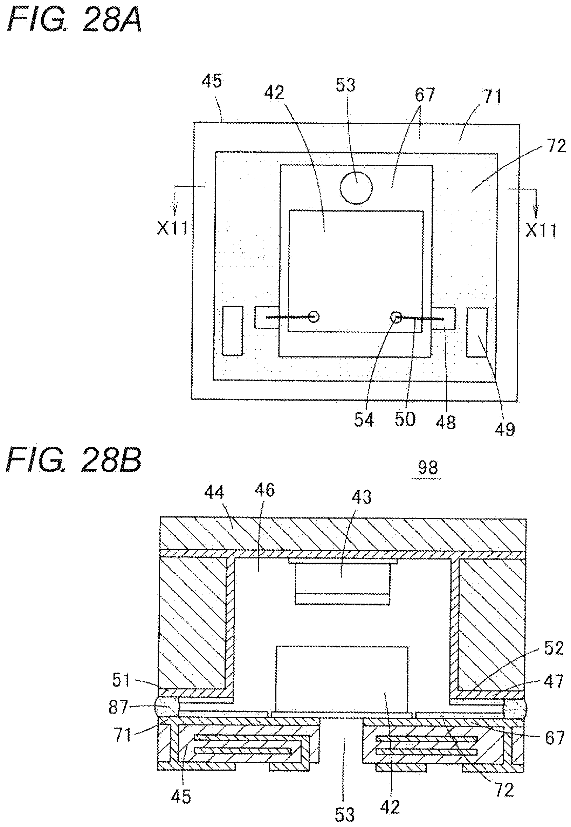

Figs. 28A and 28B are views each for describing a microphone 98 according to an eleventh embodiment of the present invention. Fig. 28A is a plan view of the substrate 45 on which the microphone chip 42 is mounted, and Fig. 28B is a cross-sectional view of the microphone 98 taken along an area corresponding to line X11-X11 in Fig. 28A.

In the microphone 98, the microphone chip 42 is mounted on the upper surface of the flat plate shaped substrate 45, and the acoustic perforation 53 is opened in the substrate 45 at a position adjacent to the microphone chip 42. Therefore, the microphone 98 is a bottom port type, and the space in the package is the front chamber.

### (Twelfth Embodiment)

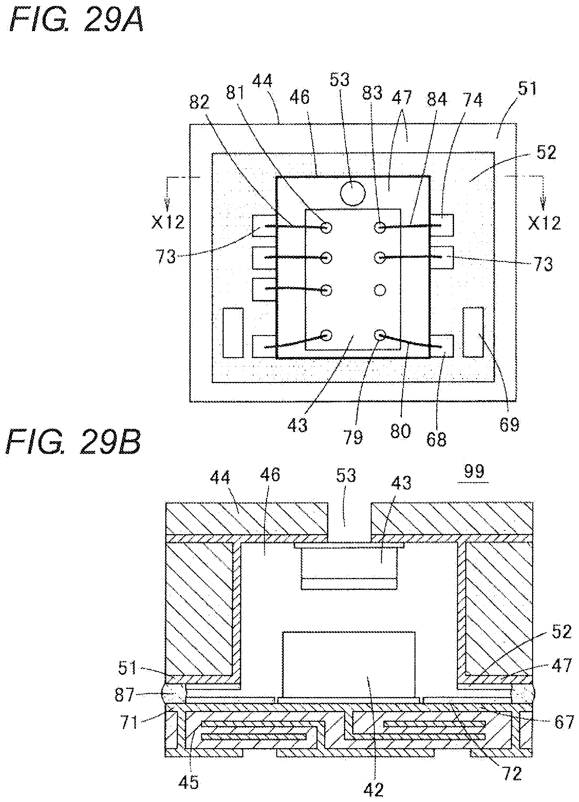

Figs. 29A and 29B are views each for describing a microphone 99 according to a twelfth embodiment of the present invention. Fig. 29A is a bottom view of the cover 44 on which the circuit element 43 is mounted, and Fig. 29B is a cross-sectional view of the microphone 99 taken along an area corresponding to line X12-X12 in Fig. 29A.

In the microphone 99, the microphone chip 42 is mounted on the upper surface of the flat plate shaped substrate 45. The circuit element 43 is mounted in the recess 46 of the cover 44 and the acoustic perforation 53 is opened in the recess 46 at a position adjacent to the circuit element 43. Therefore, the microphone 99 is a top port type, and the space in the package is the front chamber.

### (Thirteenth Embodiment)

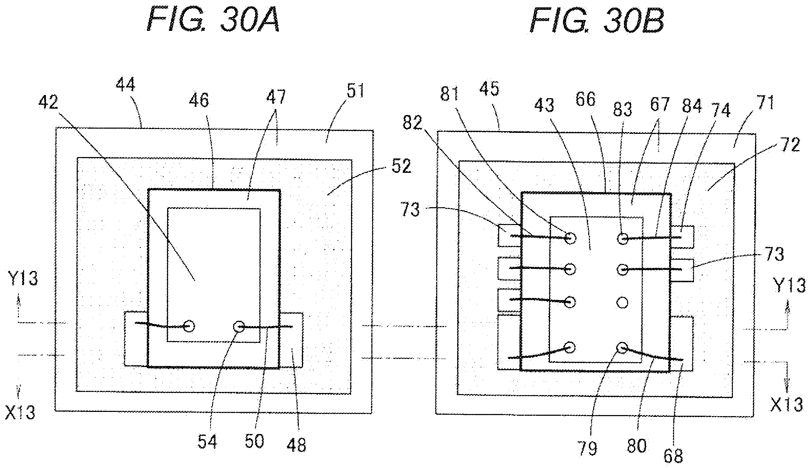

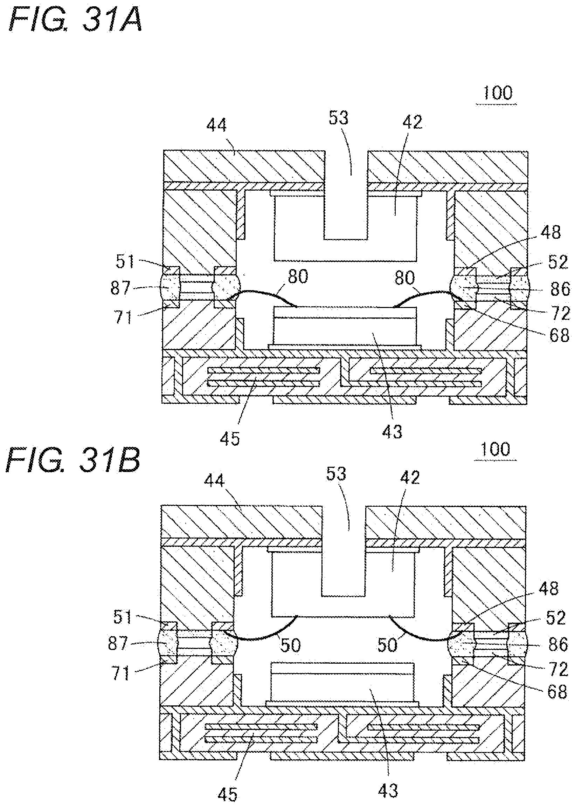

A microphone 100 according to a thirteenth embodiment of the present invention will now be described. Fig. 30A is a bottom view of the cover 44 on which the microphone chip 42 is mounted, and Fig. 30B is a plan view of the substrate 45 on which the circuit element 43 is mounted. Fig. 31A is a cross-sectional view of the microphone 100 taken along an area corresponding to line X13-X13 in Figs. 30A and 30B. Fig. 31B is a cross-sectional view of the microphone 100 taken along an area corresponding to line Y13-Y13 in Figs. 30A and 30B.

In the microphone 100, one end of the bonding wire 50 is connected to the terminal 54 of the microphone chip 42 mounted on the cover 44, and the other end of the bonding wire 50 is connected to the bonding pad 48 of the cover 44. Furthermore, one end of the bonding wire 80 is connected to the terminal 79 of the circuit element 43 mounted on the substrate 45, and the other end of the bonding wire 80 is connected to the bonding pad 68 of the substrate 45. As shown in Fig. 31A and Fig. 31B, the bonding pad 48 of the cover 44 and the bonding pad 68 of the substrate 45 are directly joined by the conductive material 86 thereby connecting the microphone chip 42 and the circuit element 43. Therefore, in the thirteenth embodiment, the cover side joining portion 49 and the substrate side joining portion 69 are not arranged.

### (Fourteenth Embodiment)

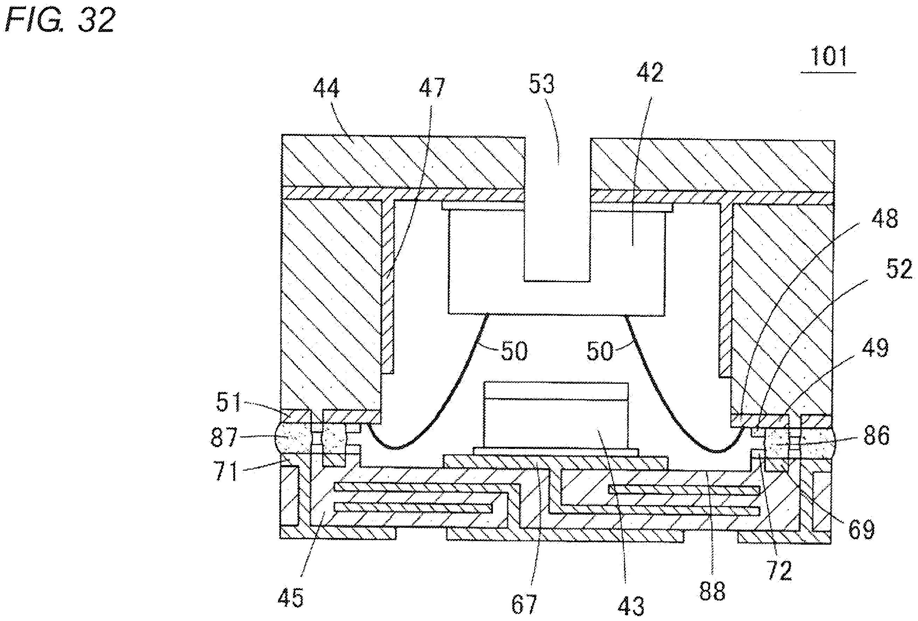

Fig. 32 is a cross-sectional view of a microphone 101 according to a fourteenth embodiment of the present invention. In this embodiment, a recessed area 88 is provided by removing the surface of the substrate 45 in the region facing the bonding pad 48 for connecting the bonding wire 50 and in the vicinity of such a region. Therefore, the bonding wire 50 is less likely to be brought into contact with the substrate 45. Similarly, a recessed area (not shown) is provided by removing the surface of the cover 44 in the region facing the bonding pad 68 for connecting the bonding wire 80 and in the vicinity of such a region. Therefore, the bonding wire 80 is less likely to be brought into contact with the cover 44.

The short circuit does not occur even if the bonding wire 50 is brought into contact with the substrate 45 if the front surface of the substrate 45 is covered with the solder resist 72. However, if the bonding wire 50 bends or deforms by contacting the substrate 45, the bonding wire 50 may be brought into contact with the conductive layer 47, or the like. Therefore, in the present embodiment, the recessed area 88 is provided in the substrate 45 to prevent the bonding wire 50 from being brought into contact with the substrate 45. This is the same for the bonding wire 80.

The microphone in which the microphone chip 42 is mounted on the cover 44 is shown in Fig. 32, but the fourteenth embodiment may be applied to the microphone in which the circuit element 43 is mounted on the cover 44.

### (Fifteenth Embodiment)

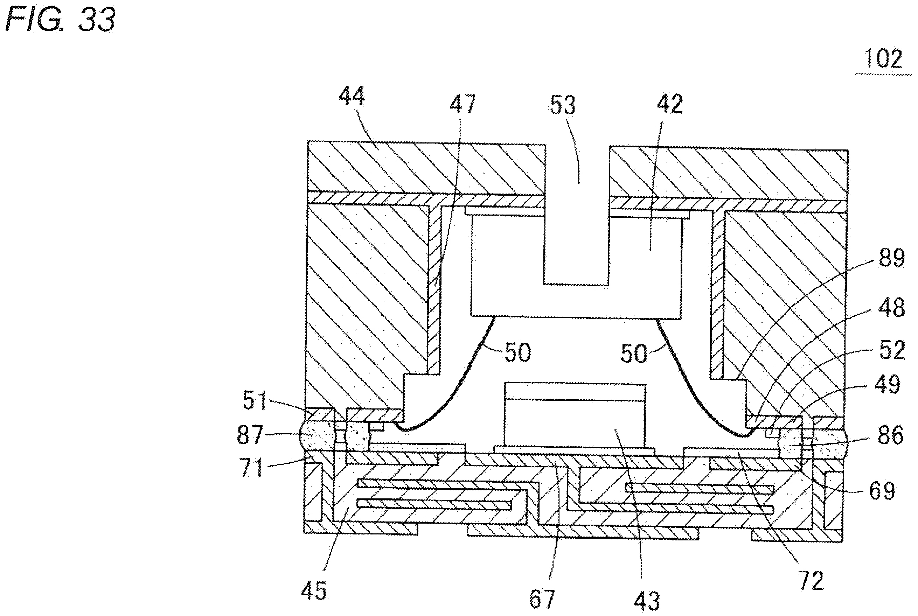

Fig. 33 is a cross-sectional view showing a microphone 102 according to a fifteenth embodiment of the present invention. In the present embodiment, the corners of the side wall portions of the cover 44 are scraped off in the passing region of the bonding wire 50 to form a cutout portion 89. The bonding wire 50 is thus less likely to contact the conductive layer 47 of the cover 44, or the like and cause short circuit.

Similarly, the corners of the side wall portions of the substrate 45 may be scraped off in the passing region of the bonding wire 80 to form a cutout portion.

The microphone in which the microphone chip 42 is mounted on the cover 44 is shown in Fig. 33, but the fifteenth embodiment may be applied to the microphone in which the circuit element 43 is mounted on the cover 44.

## Claims

1. A semiconductor device comprising:
a package including a first member (44) and a second member (45), at least one of which being formed with a recess (46, 66);
a sensor (42) mounted on an inner surface of the first member (44); and
a circuit element (43) mounted on an inner surface of the second member (45); wherein
the sensor (42) and the circuit element (43) are arranged to at least partially overlap when viewed from a direction perpendicular to a bottom surface of the package; **characterized in that**
a first bonding pad (48) is arranged on a front surface of the first member (44), the sensor (42) and the first bonding pad (48) being connected with a first wire wiring (50);
a second bonding pad (68, 73, 74) is arranged on a front surface of the second member (45), the circuit element (43) and the second bonding pad (68, 73, 74) being connected with a second wire wiring (80, 82, 84); and
the first bonding pad (48) and the second bonding pad (68, 73, 74) are arranged such that the first bonding pad (48) and the second bonding pad (68, 73, 74) are joined with a conductive material (86, 87) when joining the first member (44) and the second member (45) to form a package.

2. A semiconductor device comprising:
a package including a first member (44) and a second member (45), at least one of which being formed with a recess (46, 66);
a sensor (42) mounted on an inner surface of the first member (44); and
a circuit element (43) mounted on an inner surface of the second member (45); wherein
the sensor (42) and the circuit element (43) are arranged to at least partially overlap when viewed from a direction perpendicular to a bottom surface of the package; **characterized in that**
a first bonding pad (48) and a first joining portion (49) conducted to the first bonding pad (48) are arranged on a front surface of the first member (44), the sensor and the first bonding pad (48) being connected with a first wire wiring (50)
a second bonding pad (68, 73, 74) and a second joining portion (69) conducted to the second bonding pad (68, 73, 74) are arranged on a front surface of the second member (45), the circuit element (43) and the second bonding pad (68, 73, 74) being connected with a second wire wiring (80, 82, 84); and
the first joining portion (49) and the second joining portion (69) are arranged such that the first joining portion (49) and the second joining portion (69) are joined with a conductive material (86, 87) when joining the first member (44) and the second member (45) to form a package.

3. The semiconductor device according to claim 2, **characterized in that**
the first bonding pad (48) and the first joining portion (49) are formed from a continuous metal film, the first bonding pad (48) and the first joining portion (49) being partitioned by partially covering a front surface of the metal film with an insulating film; and
the second bonding pad (68, 73, 74) and the second joining portion (69) are formed from a continuous metal film, the second bonding pad (68, 73, 74) and the second joining portion (69) being partitioned by partially covering a front surface of the metal film with an insulating film.

4. The semiconductor device according to claim 1 or 2, **characterized in that** the conductive material is at least one of solder, conductive resin, conductive tape, or wax material.

5. The semiconductor device according to claim 1 or 2, **characterized in that** a front surface of the second member is partially removed in a region facing the first bonding pad (48) to form a space for escaping the first wire wiring (50).

6. The semiconductor device according to claim 1 or 2, **characterized in that** a front surface of the first member is partially removed in a region facing the second bonding pad (68, 73, 74) to form a space for escaping the second wire wiring (80, 82, 84).

7. The semiconductor device according to claim 1 or 2, **characterized in that** the sensor is mounted in the recess (46, 66) formed in the first member, and a corner of a peripheral wall portion surrounding the recess (46, 66) of the first member is depressed in a passing region of the first wire wiring (50).

8. The semiconductor device according to claim 1 or 2, **characterized in that** the circuit element (43) is mounted in the recess (46, 66) formed in the second member, and a corner of a peripheral wall portion surrounding the recess (46, 66) of the second member is depressed in a passing region of the second wire wiring (80, 82, 84).

9. The semiconductor device according to one of claims 1 to 8, **characterized in that** the first member is a cover of the package, and the second member is a substrate of the package.

10. The semiconductor device according to one of claims 1 to 8, **characterized in that** the first member is a substrate of the package, and the second member is a cover of the package.

11. The semiconductor device according to claim 9 or 10, **characterized in that** the cover and the substrate respectively include the recess (46, 66).

12. The semiconductor device according to claim 9 or 10, **characterized in that** the cover includes the recess (46, 66), and the substrate is formed to a flat plate shape.

13. The semiconductor device according to one of claims 1 to 12, **characterized in that** the first member is formed by at least one material of copper laminated stacked plate, glass epoxy, ceramic, plastic, metal, or carbon nano tube, or a complex material thereof.

14. The semiconductor device according to one of claim 1 to 13, **characterized in that** the second member is formed by at least one material of copper laminated stacked plate, glass epoxy, ceramic, plastic, metal, or carbon nano tube, or a complex material thereof.

15. The semiconductor device according to one of claims 1 to 14, **characterized in that** the first member and the second member have an electromagnetic shield function for shielding external electromagnetic noise.

16. A microphone (41, 91 to 102) comprising a semiconductor device according to one of claims 1 to 15, the sensor being a microphone chip (42), **characterized in that**
an acoustic perforation (53) is opened in the first member, and the microphone chip (42) is mounted on the first member to cover the acoustic perforation (53).

17. A microphone (41, 91 to 102) comprising a semiconductor device according to one of claims 1 to 15, the sensor being a microphone chip (42), **characterized in that**
an acoustic perforation (53) is opened in the first member so as not to overlap with the microphone chip (42).

18. A microphone (41, 91 to 102) comprising a semiconductor device according to one of claims 1 to 15, the sensor being a microphone chip (42), **characterized in that**
an acoustic perforation (53) is opened in the second member so as not to overlap with the circuit element (43).

## Patentansprüche

1. Halbleitervorrichtung, die Folgendes umfasst:
ein Package, das ein erstes Element (44) und ein zweites Element (45) enthält, von denen mindestens eines mit einer Aussparung (46, 66) ausgebildet ist; einen Sensor (42), der an einer Innenfläche des ersten Elements (44) montiert ist; und
ein Schaltkreiselement (43), das an einer Innenfläche des zweiten Elements (45) montiert ist;
wobei der Sensor (42) und das Schaltkreiselement (43) angeordnet sind, gesehen aus einer Richtung senkrecht zu einer Unterseite des Package mindestens teilweise zu überlappen;
**dadurch gekennzeichnet, dass**
eine erste Bondkontaktinsel (48) auf einer Vorderseite des ersten Elements (44) angeordnet ist, wobei der Sensor (42) und die erste Bondkontaktinsel (48) mit einer ersten Verdrahtung (50) verbunden sind;
eine zweite Bondkontaktinsel (68, 73, 74) auf einer Vorderseite des zweiten Elements (45) angeordnet ist, wobei das Schaltkreiselement (43) und die zweite Bondkontaktinsel (68, 73, 74) mit einer zweiten Verdrahtung (80, 82, 84) verbunden sind;
und
die erste Bondkontaktinsel (48) und die zweite Bondkontaktinsel (68, 73, 74) so angeordnet sind, dass die erste Bondkontaktinsel (48) und die zweite Bondkontaktinsel (68, 73, 74) mit einem leitfähigen Material (86, 87) verbunden werden, wenn das erste Element (44) und das zweite Element (45) verbunden werden, um ein Package zu bilden.

2. Halbleitervorrichtung, die Folgendes umfasst:
ein Package, das ein erstes Element (44) und ein zweites Element (45) enthält, von denen mindestens eines mit einer Aussparung (46, 66) ausgebildet ist;
einen Sensor (42), der an einer Innenfläche des ersten Elements (44) montiert ist; und
ein Schaltkreiselement (43), das an einer Innenfläche des zweiten Elements (45) montiert ist; wobei der Sensor (42) und das Schaltkreiselement (43) angeordnet sind, gesehen aus einer Richtung senkrecht zu einer Unterseite des Package mindestens teilweise überlappen;
**dadurch gekennzeichnet, dass**
eine erste Bondkontaktinsel (48) und ein erster Verbindungsabschnitt (49), der zu der ersten Bondkontaktinsel (48) geleitet wird, auf einer Vorderseite des ersten Elements (44) angeordnet sind, wobei der Sensor und die erste Bondkontaktinsel (48) mit einer ersten Verdrahtung (50) verbunden sind;
eine zweite Bondkontaktinsel (68, 73, 74) und ein zweiter Verbindungsabschnitt (69), der zu der zweiten Bondkontaktinsel (68, 73, 74) geleitet wird, auf einer Vorderseite des zweiten Elements (45) angeordnet sind, wobei das Schaltkreiselement (43) und die zweite Bondkontaktinsel (68, 73, 74) mit einer zweiten Verdrahtung (80, 82, 84) verbunden sind, und der erste Verbindungsabschnitt (49) und der zweite Verbindungsabschnitt (69) so angeordnet sind, dass der erste Verbindungsabschnitt (49) und der zweite Verbindungsabschnitt (69) mit einem leitfähigen Material (86, 87) verbunden werden, wenn das erste Element (44) und das zweite Element (45) verbunden werden, um ein Package zu bilden.

3. Halbleitervorrichtung nach Anspruch, **dadurch gekennzeichnet, dass**
die erste Bondkontaktinsel (48) und der erste Verbindungsabschnitt (49) aus einem kontinuierlichen Metallfilm gebildet werden, wobei die erste Bondkontaktinsel (48) und der erste Verbindungsabschnitt (49) geteilt werden, indem eine Vorderseite des Metallfilms teilweise mit einem Isolierfilm bedeckt wird; und
die zweite Bondkontaktinsel (68, 73, 74) und der zweite Verbindungsabschnitt (69) aus einem kontinuierlichen Metallfilm gebildet werden, wobei die zweite Bondkontaktinsel (68, 73, 74) und der zweite Verbindungsabschnitt (69) geteilt werden, indem eine Vorderseite des Metallfilms teilweise mit einem Isolierfilm bedeckt wird.

4. Halbleitervorrichtung nach Anspruch 1 oder 2, **dadurch gekennzeichnet, dass** das leitfähige Material mindestens eines von Lot, leitfähigem Harz, leitfähigem Band oder Wachsmaterial ist.

5. Halbleitervorrichtung nach Anspruch 1 oder 2, **dadurch gekennzeichnet, dass** eine Vorderseite des zweiten Elements teilweise in einer Region entfernt wird, die der ersten Bondkontaktinsel (48) zugewandt ist, um einen Raum zu bilden, in den die erste Verdrahtung (50) entweichen kann.

6. Halbleitervorrichtung nach Anspruch 1 oder 2, **dadurch gekennzeichnet, dass** eine Vorderseite des ersten Elements teilweise in einer Region entfernt wird, die der zweiten Bondkontaktinsel (68, 73, 74) zugewandt ist, um einen Raum zu bilden, in den die zweite Verdrahtung (80, 82, 84) entweichen kann.

7. Halbleitervorrichtung nach Anspruch 1 oder 2, **dadurch gekennzeichnet, dass** der Sensor in der Aussparung (46, 66), die in dem ersten Element ausgebildet ist, montiert ist, und eine Ecke eines Umfangswandabschnitts, der die Aussparung (46, 66) des ersten Elements umgibt, in eine Verlaufregion der ersten Verdrahtung (50) eingedrückt ist.

8. Halbleitervorrichtung nach Anspruch 1 oder 2, **dadurch gekennzeichnet, dass** das Schaltkreiselement (43) in der Aussparung (46, 66), die in dem zweiten Element ausgebildet ist, montiert ist, und eine Ecke eines Umfangswandabschnitts, der die Aussparung (46, 66) des zweiten Elements umgibt, in eine Verlaufregion der zweiten Verdrahtung (80, 82, 84) eingedrückt ist.

9. Halbleitervorrichtung nach einem der Ansprüche 1 bis 8, **dadurch gekennzeichnet, dass** das erste Element eine Abdeckung des Package ist und das zweite Element ein Substrat des Package ist.

10. Halbleitervorrichtung nach einem der Ansprüche 1 bis 8, **dadurch gekennzeichnet, dass** das erste Element ein Substrat des Package ist und das zweite Element eine Abdeckung des Package ist.

11. Halbleitervorrichtung nach Anspruch 9 oder 10, **dadurch gekennzeichnet, dass** die Abdeckung und das Substrat jeweils die Aussparung (46, 66) enthalten.

12. Halbleitervorrichtung nach Anspruch 9 oder 10, **dadurch gekennzeichnet, dass** die Abdeckung die Aussparung (46, 66) enthält und das Substrat in einer flachen Plattenform ausgebildet wird.

13. Halbleitervorrichtung nach einem der Ansprüche 1 bis 12, **dadurch gekennzeichnet, dass** das erste Element durch mindestens ein Material von kupferlaminierter gestapelter Platte, Glasepoxid, Keramik, Kunststoff, Metall, Kohlenstoffnanoröhre oder ein komplexes Material davon gebildet wird.

14. Halbleitervorrichtung nach einem der Ansprüche 1 bis 13, **dadurch gekennzeichnet, dass** das zweite Element durch mindestens ein Material von kupferlaminierter gestapelter Platte, Glasepoxid, Keramik, Kunststoff, Metall, Kohlenstoffnanoröhre oder ein komplexes Material davon gebildet wird.

15. Halbleitervorrichtung nach einem der Ansprüche 1 bis 14, **dadurch gekennzeichnet, dass** das erste Element und das zweite Element eine elektromagnetische Abschirmungsfunktion haben, um externes elektromagnetisches Rauschen abzuschirmen.

16. Mikrofon (41, 91 bis 102), das eine Halbleitervorrichtung nach einem der Ansprüche 1 bis 15 umfasst, wobei der Sensor ein Mikrofonchip (42) ist, **dadurch gekennzeichnet, dass** eine akustische Perforation (53) in dem ersten Element geöffnet ist, und der Mikrofonchip (42) an dem ersten Element montiert ist, um die akustische Perforation (53) zu bedecken.

17. Mikrofon (41, 91 bis 102), das eine Halbleitervorrichtung nach einem der Ansprüche 1 bis 15 umfasst, wobei der Sensor ein Mikrofonchip (42) ist, **dadurch gekennzeichnet, dass** eine akustische Perforation (53) in dem ersten Element geöffnet ist, dergestalt, dass sie nicht den Mikrofonchip (42) überlappt.

18. Mikrofon (41, 91 bis 102), das eine Halbleitervorrichtung nach einem der Ansprüche 1 bis 15 umfasst, wobei der Sensor ein Mikrofonchip (42) ist, **dadurch gekennzeichnet, dass** eine akustische Perforation (53) in dem zweiten Element geöffnet ist, dergestalt, dass sie nicht das Schaltkreiselement (43) überlappt.

## Revendications

1. Dispositif semi-conducteur comprenant :
un boîtier incluant un premier élément (44) et un second élément (45), au moins un de ceux-ci étant doté d'un évidement (46, 66) ;
un capteur (42) monté sur une surface intérieure du premier élément (44) ; et
un élément de circuit (43) monté sur une surface intérieure du second élément (45) ; dans lequel
le capteur (42) et l'élément de circuit (43) sont agencés pour se chevaucher au moins en partie lorsqu'ils sont vus depuis une direction perpendiculaire à une surface inférieure du boîtier ; **caractérisé en ce que**
un premier plot de contact (48) est agencé sur une surface avant du premier élément (44), le capteur (42) et le premier plot de contact (48) étant connectés à un premier câblage à câble (50) ;
un second plot de contact (68, 73, 74) est agencée sur une surface avant du second élément (45), l'élément de circuit (43) et le second plot de contact (68, 73, 74) étant connectés à un second câblage à câble (80, 82, 84) ; et
le premier plot de contact (48) et le second plot de contact (68, 73, 74) sont agencées de sorte que le premier plot de contact (48) et le second plot de contact (68, 73, 74) soient raccordées avec un matériau conducteur (86, 87) lors du raccordement du premier élément (44) et du second élément (45) pour former un boîtier.

2. Dispositif semi-conducteur comprenant :
un boîtier incluant un premier élément (44) et un second élément (45), au moins un de ceux-ci étant doté d'un évidement (46, 66) ;
un capteur (42) monté sur une surface intérieure du premier élément (44) ; et
un élément de circuit (43) monté sur une surface intérieure du second élément (45) ; dans lequel
le capteur (42) et l'élément de circuit (43) sont agencés pour se chevaucher au moins en partie lorsqu'ils sont vus depuis une direction perpendiculaire à une surface inférieure du boîtier ; **caractérisé en ce que**
un premier plot de contact (48) et une première portion de raccordement (49) en conduction avec le premier plot de contact (48) sont agencées sur une surface avant du premier élément (44), le capteur et le premier plot de contact (48) étant connectés à un premier câblage à câble (50),
un second plot de contact (68, 73, 74) et une seconde portion de raccordement (69) en conduction avec le second plot de contact (68, 73, 74) sont agencées sur une surface avant du second élément (45), l'élément de circuit (43) et le second plot de contact (68, 73, 74) étant connectés à un second câblage à câble (80, 82, 84) ; et la première portion de raccordement (49) et la seconde portion de raccordement (69) sont agencées de sorte que la première portion de raccordement (49) et la seconde portion de raccordement (69) soient raccordées avec un matériau conducteur (86, 87) lors du raccordement du premier élément (44) et du second élément (45) pour former un boîtier.

3. Dispositif semi-conducteur selon la revendication 2, **caractérisé en ce que**
le premier plot de contact (48) et la première portion de raccordement (49) sont constituées d'un fil métallique continu, le premier plot de contact (48) et la première portion de raccordement (49) étant divisées en recouvrant en partie une surface avant du film métallique avec un film isolant ; et
le second plot de contact (68, 73, 74) et la seconde portion de raccordement (69) sont constituées d'un film métallique continu, le second plot de contact (68, 73, 74) et la seconde portion de raccordement (69) étant divisées en recouvrant en partie une surface avant du film métallique avec un film isolant.

4. Dispositif semi-conducteur selon la revendication 1 ou 2, **caractérisé en ce que** le matériau conducteur est au moins un parmi une soudure, une résine conductrice, un ruban conducteur ou un matériau cireux.

5. Dispositif semi-conducteur selon la revendication 1 ou 2, **caractérisé en ce qu'**une surface avant du second élément est en partie retirée dans une région faisant face au premier plot de contact (48) pour former un espace pour que le premier câblage à câble (50) s'échappe.

6. Dispositif semi-conducteur selon la revendication 1 ou 2, **caractérisé en ce qu'**une surface avant du premier élément est retirée en partie dans une région faisant face au second plot de contact (68, 73, 74) pour former un espace pour que le second câblage à câble (80, 82, 84) s'échappe.

7. Dispositif semi-conducteur selon la revendication 1 ou 2, **caractérisé en ce que** le capteur est monté dans l'évidement (46, 66) formé dans le premier élément, et un coin d'une portion de paroi périphérique entourant l'évidement (46, 66) du premier élément est baissé dans une région de passage du premier câblage à câble (50).

8. Dispositif semi-conducteur selon la revendication 1 ou 2, **caractérisé en ce que** l'élément de circuit (43) est monté dans l'évidement (46, 66) formé dans le second élément, et un coin d'une portion de paroi périphérique entourant l'évidement (46, 66) du second élément est baissé dans une région de passage du premier câblage à câble (80, 82, 84).

9. Dispositif semi-conducteur selon l'une des revendications 1 à 8, **caractérisé en ce que** le premier élément est un capot du boîtier, et le second élément est un substrat du boîtier.

10. Dispositif semi-conducteur selon l'une des revendications 1 à 8, **caractérisé en ce que** le premier élément est un substrat du boîtier, et le second élément est un capot du boîtier.

11. Dispositif semi-conducteur selon la revendication 9 ou 10, **caractérisé en ce que** le capot et le substrat incluent respectivement l'évidement (46, 66) .

12. Dispositif semi-conducteur selon la revendication 9 ou 10, **caractérisé en ce que** le capot inclut l'évidement (46, 66), et le substrat est formé pour avoir une forme de plaque plate.

13. Dispositif semi-conducteur selon l'une des revendications 1 à 12, **caractérisé en ce que** le premier élément est constitué d'au moins un matériau de plaque empilée laminée en cuivre, de verre époxydique, de céramique, de plastique, de métal ou de nanotube de carbone, ou d'un matériau complexe de ceux-ci.

14. Dispositif semi-conducteur selon l'une des revendications 1 à 13, **caractérisé en ce que** le second élément est constitué d'au moins un matériau de plaque empilée laminée en cuivre, de verre époxydique, de céramique, de plastique, de métal ou de nanotube de carbone, ou d'un matériau complexe de ceux-ci.

15. Dispositif semi-conducteur selon l'une des revendications 1 à 14, **caractérisé en ce que** le premier élément et le second élément ont une fonction d'écran électromagnétique pour faire écran au bruit électromagnétique externe.

16. Microphone (41, 91 à 102) comprenant un dispositif semi-conducteur selon l'une des revendications 1 à 15, le capteur étant une puce de microphone (42), **caractérisé en ce que**
une perforation acoustique (53) est ouverte dans le premier élément, et la puce de microphone (42) est montée sur le premier élément pour recouvrir la perforation acoustique (53).

17. Microphone (41, 91 à 102) comprenant un dispositif semi-conducteur selon l'une des revendications 1 à 15, le capteur étant une puce de microphone (42), **caractérisé en ce que**
une perforation acoustique (53) est ouverte dans le premier élément de manière à ne pas chevaucher la puce de microphone (42).

18. Microphone (41, 91 à 102) comprenant un dispositif semi-conducteur selon l'une des revendications 1 à 15, le capteur étant une puce de microphone (42), **caractérisé en ce que**
une perforation acoustique (53) est ouverte dans le second élément de manière à ne pas chevaucher l'élément de circuit (43).
